# EUROPEAN PATENT APPLICATION

(11) **EP 3 300 260 A2**
(43) Date of publication of application: **28.03.2018**
(21) Application number: 17192442.6
(22) Date of filing: 21.09.2017
(51) Int. Cl.: H04B 5/00, H01Q 1/24, H01Q 7/00, H02J 5/00, H02J 50/10

(54) **APPARATUS AND METHOD FOR WIRELESS POWER TRANSMISSION AND/OR RECEPTION IN**

(30) Priority: 23.09.2016 KR 20160122183
(71) Applicant: Samsung Electronics Co., Ltd., Gyeonggi-do 16677 (KR)
(72) Inventor: Lee, Hee Dong, Gumi-si (KR); Lee, Ji-Woo, Gumi-si (KR)
(74) Representative: Nederlandsch Octrooibureau

(57) **Abstract**

Disclosed is an electronic device that includes a housing, a display, and a conductive line extending from a first end part to a second end part to include a plurality of turns that surround a space between a first surface and a second surface of the housing, and generating a magnetic field in the first direction or second direction or of a direction perpendicular to the first or second direction. As such, the electronic device may receive wireless power from a wireless charging device even if the electronic device is mounted on the wireless charging device in various directions.

## Description

### BACKGROUND

### 1. Field of the Disclosure

The present disclosure relates generally to an electronic device, and more particularly, to an apparatus and method for wireless power transmission and/or reception in an electronic device.

### 2. Description of the Related Art

By using a magnetic field, an electronic device can wirelessly receive power from an external device and can perform wireless communication such as mobile communication or wireless Internet. The electronic device can include an antenna for wireless power reception and an antenna for wireless communication, and can be charged using a wireless charging device. For example, if the electronic device is mounted on the wireless charging device, power from the wireless charging device can be forwarded to the electronic device in an electromagnetic induction scheme.

Although the electronic device is mounted on the wireless charging device, if an antenna of the electronic device and an antenna of the wireless charging device are not aligned with each other, it can be difficult to forward the power from the wireless charging device to the electronic device. Also, a manufacturing company generally provides a mutually different wireless charging device on a per-electronic-device basis. Thus, if a dedicated wireless charging device is not provided, it can be difficult to wirelessly charge the electronic device.

As such, there is a need in the art for an improved wireless charging method and apparatus in an electronic device mounted on a wireless charging device.

### SUMMARY

The present disclosure has been made to address the above problems and disadvantages, and to provide at least the advantages described below. Accordingly, an aspect of the present disclosure is to provide an apparatus and method for wireless power transmission and/or reception in an electronic device capable of receiving wireless power from a wireless charging device even if the electronic device is mounted on the wireless charging device in various directions.

Another aspect of the present disclosure is to provide an apparatus and method for wireless power transmission and/or reception in an electronic device capable of receiving wireless power using another electronic device in place of a dedicated wireless charging device.

According to an aspect of the present disclosure, an electronic device may include a housing including a first surface facing in a first direction, and a second surface facing in a second direction that is opposite to the first direction, a display disposed between the first surface and the second surface, and exposed through the first surface, and a conductive line extending from a first end part to a second end part and including a plurality of turns that surround a space between the first surface and the second surface, and generating a magnetic field in the first direction or the second direction, or generating the magnetic field in a direction perpendicular to the first direction or the second direction.

According to another aspect of the present disclosure, an electronic device may include a housing including a first surface facing in a first direction, and a second surface facing in a second direction that is opposite to the first direction, a display disposed between the first surface and the second surface, and exposed through the first surface, and a flexible film of a ring form and including a plurality of conductive lines, and surrounding a space between the first surface and second surface, wherein the conductive lines are electrically connected to one another, and form one conductive line that is extended from a first end part to a second end part to include a plurality of turns, and wherein the one conductive line generates a magnetic field in the first direction or second direction or a magnetic field in a direction perpendicular to the first direction or the second direction.

According to another aspect of the present disclosure, a method for operating in an electronic device may include
receiving a request for a light receiving mode from an external electronic device, entering the light receiving mode, transmitting a signal on the light receiving mode to the external electronic device, when an optical signal generated from the external electronic device is detected, releasing the light receiving mode when a request for a wireless power reception mode according to the signal is received from the external electronic device, and entering the wireless power reception mode and receiving wireless power from the external electronic device.

### BRIEF DESCRIPTION OF THE DRAWINGS

The above and other aspects, features, and advantages of the present disclosure will be more apparent from the following detailed description, taken in conjunction with the accompanying drawings, in which:
FIG. 1 illustrates a network environment system according to an embodiment of the present disclosure;
FIG. 2 illustrates an electronic device according to embodiments of the present disclosure;
FIG. 3 illustrates a program module according to embodiments of the present disclosure;
FIG. 4A illustrates an electronic device capable of performing wireless power transmission and/or reception according to an embodiment of the present disclosure;
FIGS. 4B and 4C illustrate a relationship between elements of an electronic device capable of performing wireless power transmission and/or reception according to an embodiment of the present disclosure;
FIGS. 4D, 4E and 4F illustrate an arrangement structure of an antenna according to an embodiment of the present disclosure;
FIGS. 5A and 5B illustrate a structure of an electronic device capable of performing wireless power transmission and/or reception according to an embodiment of the present disclosure;
FIG. 6 illustrates an antenna according to an embodiment of the present disclosure;
FIGS. 7A, 7B, 7C and 7D illustrate a wiring structure of an antenna according to an embodiment of the present disclosure;
FIGS. 8A and 8B illustrate wireless power transmission and/or reception between an electronic device and an external electronic device according to an embodiment of the present disclosure;
FIG. 9 illustrates a structure of an external electronic device capable of performing wireless power transmission and/or reception according to an embodiment of the present disclosure;
FIG. 10A illustrates an antenna installation portion in an electronic device capable of performing wireless power transmission and/or reception according to an embodiment of the present disclosure;
FIG. 10B illustrates an antenna installed in an electronic device capable of performing wireless power transmission and/or reception according to an embodiment of the present disclosure;
FIGS. 11A and 11B illustrate a structure of an electronic device capable of performing wireless power transmission and/or reception according to an embodiment of the present disclosure;
FIG. 12 illustrates a structure of an antenna according to an embodiment of the present disclosure;
FIG. 13 illustrates wireless power transmission and/or reception between an electronic device and an external electronic device according to an embodiment of the present disclosure;
FIGS. 14A and 14B illustrate a structure of an electronic device capable of performing wireless power transmission and/or reception according to an embodiment of the present disclosure;
FIGS. 15A, 15B, 16A and 16B illustrate a wiring structure of an antenna according to embodiments of the present disclosure;
FIGS. 16C and 16D illustrate a wiring structure of an antenna according to another embodiment of the present disclosure;
FIG. 17 illustrates an electronic device capable of transmitting and/or receiving wireless power according to an embodiment of the present disclosure;
FIG. 18 illustrates an electronic device capable of providing wireless power according to an embodiment of the present disclosure;
FIG. 19 illustrates a method of a power transmission apparatus according to an embodiment of the present disclosure;
FIG. 20 illustrates a method of a power reception apparatus according to an embodiment of the present disclosure;
FIGS. 21A, 21B and 21C illustrate a method of a power transmission apparatus according to an embodiment of the present disclosure;
FIG. 22 illustrates a method of a power transmission apparatus according to an embodiment of the present disclosure;
FIG. 23 illustrates a method of a power reception apparatus according to an embodiment of the present disclosure; and
FIG. 24 illustrates a method of a power transmission apparatus according to an embodiment of the present disclosure.

### DETAILED DESCRIPTION OF EMBODIMENTS OF THE PRESENT DISCLOSURE

Embodiments of the present disclosure are described below with reference to the accompanying drawings. The embodiments and terms used in the present disclosure are not intended to limit the present disclosure to a specific form, and should be construed as including various changes, equivalents, and/or alternatives of the corresponding embodiment of the present disclosure. In relation with the description of the drawings, like reference symbols may denote like elements. Descriptions of well-known functions and/or configurations will be omitted for the sake of clarity and conciseness.

Expressions of a singular form may include plural forms unless clearly stated otherwise. In the present disclosure, expressions such as "A or B" and "at least one of A and/or B" may include all available combinations of words enumerated together. Terms such as "1st", "2nd", "first", and "second" may modify corresponding elements irrespective of order or importance, and are merely used to distinguish one element from another element and not to limit the corresponding elements. When it is described that an element, such as a first element, is operatively or communicatively coupled with/to or connected to another element, such as a second element, the first element may be directly coupled to the second element, or coupled to the second element through another element, such as a third element.

In the present disclosure, the expression "configured (or set) to" may be used interchangeably with "suitable for", "having the capacity to", "adapted to", "made to", "capable of", or "designed to" in a hardware or software manner in accordance to circumstances. In any situation, the expression "device configured to" may represent that the device is "capable of" together with other devices or components. For example, the phrase "processor configured (or set) to perform A, B, and C" may represent an embedded processor for performing a corresponding operation, or a generic-purpose processor, such as a central processing unit (CPU) or an application processor (AP), capable of performing corresponding operations by executing one or more software programs stored in a memory device.

An electronic device according to embodiments of the present disclosure may include at least one of a smartphone, a tablet personal computer (PC), a mobile phone, a video phone, an electronic book reader, a desktop PC, a laptop PC, a netbook computer, a workstation, a server, a personal digital assistant (PDA), a portable multimedia player (PMP), a motion pictures experts group (MPEG)-1 audio layer-3 (MP3) player, a medical device, a camera, or a wearable device. The wearable device may include at least one of an accessory type, such as a watch, ring, wristlet, anklet, necklace, glasses, contact lens, or head-mounted-device (HMD), fabric or clothing integral type, such as electronic clothes, human-body mount type, such as a skin pad or tattoo, or bio implantation type circuit. In some embodiments, the electronic device may include at least one of a television (TV), a digital video disc (DVD) player, an audio system, a refrigerator, an air conditioner, a cleaner, an oven, a microwave, a washing machine, an air cleaner, a set-top box, a home automation control panel, a security control panel, a media box, such as Samsung HomeSync™, Apple TV™, or Google TV™, a game console, such as Xbox™ or PlayStation™, an electronic dictionary, an electronic locking system, a camcorder, or an electronic frame.

In another embodiment, the electronic device may include at least one of various medical devices, such as portable medical measurement devices, including a blood glucose sensor, a heat rate sensor, a blood pressure monitor, or a body temperature meter, magnetic resonance angiography (MRA), magnetic resonance imaging (MRI), computed tomography (CT), a photographing machine, or an ultrasonic machine, a navigation device, a global navigation satellite system (GNSS), an event data recorder (EDR), a flight data recorder (FDR), a car infotainment device, electronic equipment for ship, such as a navigation device or a gyrocompass, avionics, a security device, a head unit for car, an industrial or home robot, a drone, an automated teller machine (ATM), a point of sales (POS) device, or an Internet of Things (IoT) device, such as an electric light bulb, various sensors, a sprinkler device, a fire alarm, a thermostat, a streetlight, a toaster, an exerciser, a hot water tank, a heater, or a boiler.

The electronic device may include at least part of furniture, a building/structure or a car, an electronic board, an electronic signature receiving device, a projector, or various metering devices, such as tap water, electricity, gas, or radio wave metering devices. In various exemplary embodiments, the electronic device may be flexible, or be a combination of at least two of the aforementioned devices. The electronic device according to the present disclosure is not limited to the aforementioned devices. In the present disclosure, the term 'user' may denote a person who uses the electronic device or an artificial-intelligence electronic device which uses the electronic device.

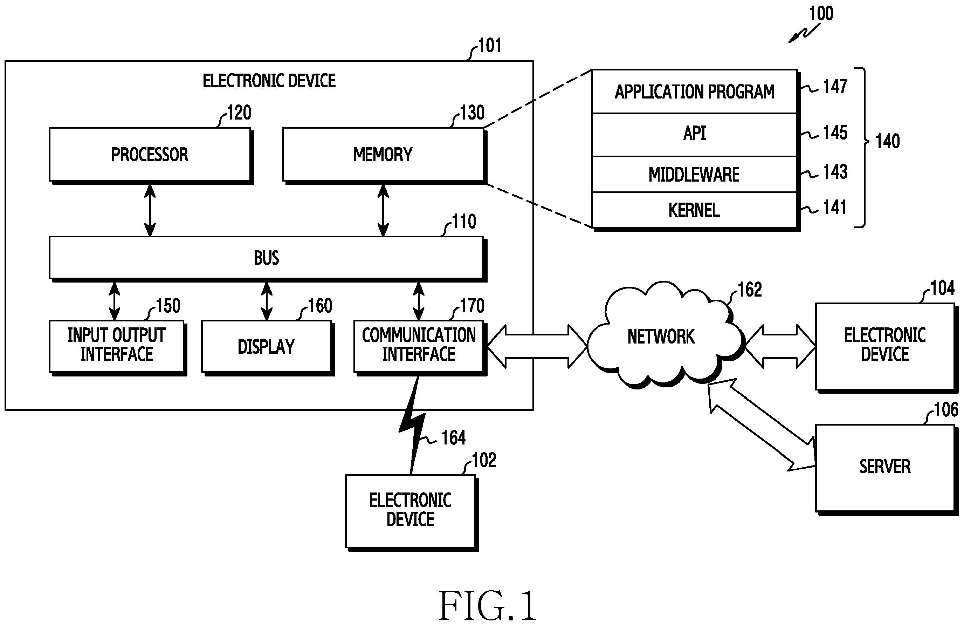

FIG. 1 illustrates a network environment system according to an embodiment of the present disclosure.

Referring to FIG. 1, an electronic device 101 within a network environment 100 may include a bus 110, a processor 120, a memory 130, an input output interface 150, a display 160, and a communication interface 170. In some embodiments, the electronic device 101 may omit at least one of the elements or additionally have another element. The bus 110 may include a circuit coupling the elements 120, 130, 150, 160 and 170 with one another and forwarding communication between the elements. A control message or data between the elements may be exchange via the circuit of the bus 110. The processor 120 may include one or more of a CPU, an AP, or a communication processor (CP), and may execute operation or data processing for control and/or communication of at least one another element of the electronic device 101.

The memory 130 may include a volatile and/or non-volatile memory, and may store a command or data related to at least one another element of the electronic device 101. For example, the memory 130 may store, software and/or program 140 including a kernel 141, middleware 143, an application programming interface (API) 145, an application program (or "applications") 147. At least some of the kernel 141, the middleware 143, or the API 145 may be referred to as an operating system (OS). The kernel 141 may control or manage system resources such as the bus 110, the processor 120, the memory 130 or the like that are used for executing operations or functions implemented in other programs such as the middleware 143, the API 145, or the applications 147). Also, the kernel 141 may provide an interface through which the middleware 143, the API 145 or the applications 147 may control or manage the system resources of the electronic device 101 by accessing the individual element of the electronic device 101.

The middleware 143 may perform a relay role of enabling the API 145 or the applications 147 to communicate and exchange data with the kernel 141. Also, the middleware 143 may process one or more work requests that are received from the applications 147, in accordance with priority. For example, the middleware 143 may grant at least one of the applications 147 priority capable of using the system resources such as the bus 110, the processor 120, the memory 130 or the like of the electronic device 101, and process one or more work requests. The API 145 enables the applications 147 to control a function provided by the kernel 141 or the middleware 143 and may include at least one interface or function for file control, window control, image processing, or character control. The input output interface 150 may forward a command or data inputted from a user or another external device, to another element(s) of the electronic device 101, or output a command or data received from another element(s) of the electronic device 101, to the user or another external device.

The display 160 may include a liquid crystal display (LCD), a light emitting diode (LED) display, an organic light emitting diode (OLED) display, a microelectromechanical systems (MEMS) display, or an electronic paper display, may display various contents to a user. According to one embodiment, the display 160 may include a touch screen that may receive a touch, gesture, proximity, or hovering input from an electronic pen or a part of the user's body. The communication interface 170 may establish communication between the electronic device 101 and an external device, such as the first external electronic device 102, the second external electronic device 104, or the server 106. For example, the communication interface 170 may be coupled to a network 162 through wireless communication or wired communication, to communicate with one of the external devices such as the second external device 104 or the server 106.

The wireless communication may include a cellular communication that uses at least one of long term evolution (LTE), LTE-advanced (LTE-A), code division multiple access (CDMA), wideband CDMA (WCDMA), universal mobile telecommunications system (UMTS), wireless broadband (WiBro), global system for mobile communications (GSM). According to various embodiments, the wireless communication may include short-range communication 164, such as wireless fidelity (WiFi), Bluetooth™ (BT), Bluetooth low energy (BLE), Zigbee™, near field communication (NFC), magnetic secure transmission (MST), radio frequency (RF), or body area network (BAN).

According to various embodiments, The wireless communication may include a global navigation satellite system (GNSS), such as a global positioning system (GPS), a global navigation satellite system (Glonass), Beidou navigation satellite system (Beidou), or the European global satellite-based navigation system (Galileo). In the present disclosure, "GPS" may be used interchangeably with "GNSS". The wired communication may include at least one of a universal serial bus (USB), a high definition multimedia interface (HDMI), a recommended standard-232 (RS-232), power line communication (PLC), or a plain old telephone service (POTS). According various embodiments, the network 162 may include a telecommunication network including at least one of local area network (LAN) or wide area network (WAN), the Internet, or a telephone network.

Each of the first and second electronic devices 102 and 104 may be the same type as or different type than the electronic device 101. According to embodiments, all or some of the operations executed in the electronic device 101 may be executed in at least one other electronic device such as the electronic devices 102 and 104 or the server 106. When the electronic device 101 will have to perform some function or service automatically or in response to a request, the electronic device 101 may, instead of or additionally to executing the function or service in itself, send a request for execution of at least a partial function associated with this to another device, which may execute the requested function or an additional function, and forward the execution result to the electronic device 101. The electronic device 101 may process the received result as it is or additionally, to provide the requested function or service. For this, a cloud, distributed, or client-server computing technology may be used.

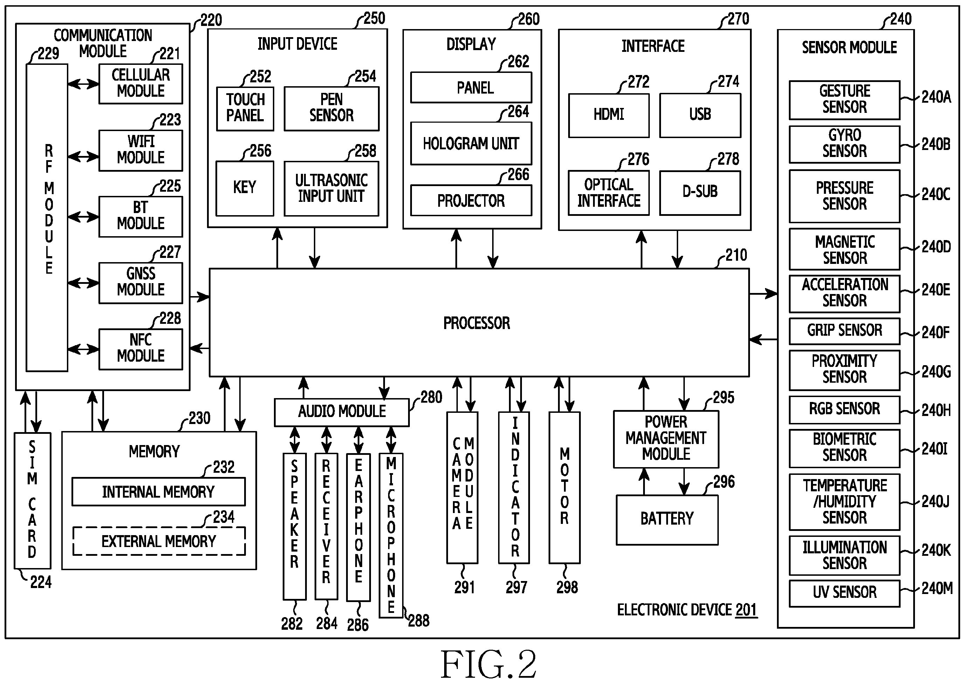

FIG. 2 illustrates an electronic device 201 according to embodiments of the present disclosure. The electronic device 201 may include the entire or part of the electronic device 101 illustrated in FIG. 1. For example, the electronic device 201 may include at least one application processor (AP) 210, a communication module 220, a subscriber identification module (SIM) card 224, a memory 230, a sensor module 240, an input device 250, a display 260, an interface 270, an audio module 280, a camera module 291, a power management module 295, a battery 296, an indicator 297, or a motor 298.

The processor 210 may drive an OS or an application program, to control a majority of hardware or software elements coupled to the processor 210 and perform various data processing and operations. According to an embodiment, the processor 210 may and be implemented as a system on chip (SoC). According to an embodiment, the processor 210 may further include a graphic processing unit (GPU) and/or an image signal processor (ISP). According to an embodiment, the processor 210 may include at least some of the elements in FIG. 2, such as cellular module 221. The processor 210 may load, to a volatile memory, a command or data received from at least one of the other elements, such as non-volatile memory, to process the command or data, and store the result data in the non-volatile memory.

The communication module 220 may have the same or a similar construction as the communication interface 170 of the electronic device 101 of FIG. 1. For example, the communication module 220 may include a cellular module 221, a WiFi module 223, a Bluetooth (BT) module 225, a GNSS module 227, an NFC module 228, and an RF module 229. The cellular module 221 may provide voice telephony, video telephony, a text service, or an Internet service through a telecommunication network. The cellular module 221 may perform the distinction and authentication of the electronic device 201 within the telecommunication network, using the SIM card 224. The cellular module 221 may perform at least some functions among functions the processor 210 may provide. According to an embodiment, the cellular module 221 may include a CP. According to various embodiments, at least two of the cellular module 221, the WiFi module 223, the Bluetooth module 225, the GNSS module 227 and the NFC module 228 may be included within one integrated chip (IC) or IC package.

The RF module 229 may transmit and/or receive a communication signal, such as RF signal. The RF module 229 may include a transceiver, a power amplifier module (PAM), a frequency filter, a low noise amplifier (LNA), or an antenna. According to another embodiment, at least one of the cellular module 221, the WiFi module 223, the Bluetooth module 225, the GNSS module 227 and the NFC module 228 may transmit and/or receive an RF signal through a separate RF module. The SIM card 224 may be a card including a SIM and/or an embedded SIM, and may include unique identification information, such as integrated circuit card identifier (ICCID) or subscriber information, such as international mobile subscriber identity (IMSI).

The memory 230 such as the memory 130 of FIG. 1 may include an internal memory 232 or an external memory 234. The internal memory 232 may include at least one of a volatile memory, such as a dynamic random access memory (DRAM), a static RAM (SRAM), a synchronous dynamic RAM (SDRAM), and/or a non-volatile memory, such as one time programmable read only memory (OTPROM), a programmable ROM (PROM), an erasable PROM (EPROM), an electrically EPROM (EEPROM), a mask ROM, a flash ROM, a flash memory, a hard drive, or a solid state drive (SSD). The external memory 234 may include a flash drive a compact flash (CF), a secure digital (SD), a micro-SD, a mini-SD, an extreme digital (xD), a multimedia card (MMC), or a memory stick, and may be operatively or physically coupled with the electronic device 201 through various interfaces.

The sensor module 240 may measure a physical quantity or sense an activation state of the electronic device 201, to convert measured or sensed information into an electric signal. For example, the sensor module 240 may include at least one of a gesture sensor 240A, a gyro sensor 240B, a barometer 240C, a magnetic sensor 240D, an acceleration sensor 240E, a grip sensor 240F, a proximity sensor 240G, a red, green, blue (RGB) sensor 240H such as a color sensor, a medical sensor 240I, a temperature-humidity sensor 240J, an illuminance sensor 240K, or an ultra violet (UV) sensor 240M. According to another embodiment, the sensor module 240 may include an E-nose sensor, an electromyography (EMG) sensor, an electroencephalogram (EEG) sensor, an electrocardiogram (ECG) sensor, an infrared (IR) sensor, an iris scan sensor, a finger scan sensor. According to an embodiment, the sensor 240 may further include a control circuit for controlling at least one or more sensors installed therein, and a processor configured to control the sensor module 240 as a part of the processor 210 or separately, while the processor 210 is in a sleep state.

The input device 250 may include a touch panel 252, a (digital) pen sensor 254, a key 256, or an ultrasonic input device 258. The touch panel 252 may use at least one scheme among a capacitive overlay scheme, a pressure sensitive scheme, an infrared beam scheme, or an ultrasonic scheme. According to an embodiment, the touch panel 252 may further include a control circuit. According to an embodiment, the touch panel 252 may further include a tactile layer to provide a tactile response to a user. The (digital) pen sensor 254 may be a part of the touch panel 252, or include a separate sheet for recognition. The key 256 may include a physical button, an optical key, or a keypad. The ultrasonic input device 258 may sense an ultrasonic wave generated in an input tool through a microphone 288, to confirm data corresponding to the sensed ultrasonic wave.

The display 260 may include a panel 262, a hologram device 264, a projector 266, and/or a control circuit for controlling the panel 262, hologram device 264, and projector 266. According an embodiment, the panel 262 may be implemented to be flexible, transparent, or wearable. According an embodiment, the panel 262 may be configured as one or more modules together with the touch panel 252. For example, the panel 262 may include a pressure sensor (or force sensor) capable of measuring a pressure intensity of a user's touch. The pressure sensor may be implemented as an integral type with the touch panel 252, or as one or more sensors separate from the touch panel 252. The hologram device 264 may show a three-dimensional image to the air using the interference of light. The projector 266 may project light onto a screen, to display an image. The screen may be located inside or outside the electronic device 201. The interface 270 may include an HDMI 272, a USB 274, an optical interface 276, and a D-subminiature (D-sub) 278. The interface 270 may be included in the communication interface 170 illustrated in FIG. 1. According to various embodiments, the interface 270 may include a mobile high-definition link (MHL) interface, an SD card / multimedia card (MMC) interface, or an infrared data association (IrDA) standard interface.

The audio module 280 may convert a sound and an electric signal interactively. At least some elements of the audio module 280 may be included in the input output interface 150 illustrated in FIG. 1. The audio module 280 may process sound information that is inputted or outputted through a speaker 282, a receiver 284, earphones 286, or the microphone 288. The camera module 291 is able to photograph a still image and a video, and may include one or more image sensors, such as front sensor or rear sensor, a lens, an image signal processor (ISP), or a flash, such as an LED or a xenon lamp. The power management module 295 may manage power of the electronic device 201 and may include a power management integrated circuit (PMIC), a charger IC, or a battery gauge. The PMIC may employ a wired and/or wireless charging scheme. The wireless charging scheme may include a magnetic resonance scheme, a magnetic induction scheme, or an electromagnetic wave scheme, and a supplementary circuit for wireless charging a coil loop, a resonance circuit, or a rectifier. The battery gauge may measure a level of the battery 296, a voltage being in charge, an electric current or a temperature, and may include a rechargeable battery and/or a solar battery.

The indicator 297 may display a specific state of the electronic device 201 or a part such as the processor 210 of the electronic device 201. For example, the specific sate may include a booting, message, or charging state. The motor 298 may convert an electric signal into a mechanical vibration, and may generate a vibration or a haptic effect. The electronic device 201 may include a mobile TV support device, such as a GPU, capable of processing media data according to the standards of digital multimedia broadcasting (DMB), digital video broadcasting (DVB), or mediaFlo™. The elements described in the present disclosure each may consist of one or more components, and a name of the corresponding element may become different according to the kind of an electronic device. The electronic device 201 may omit some elements, or further include additional elements, or combine some of elements to configure the same as one entity, but identically perform functions of the corresponding elements before combination.

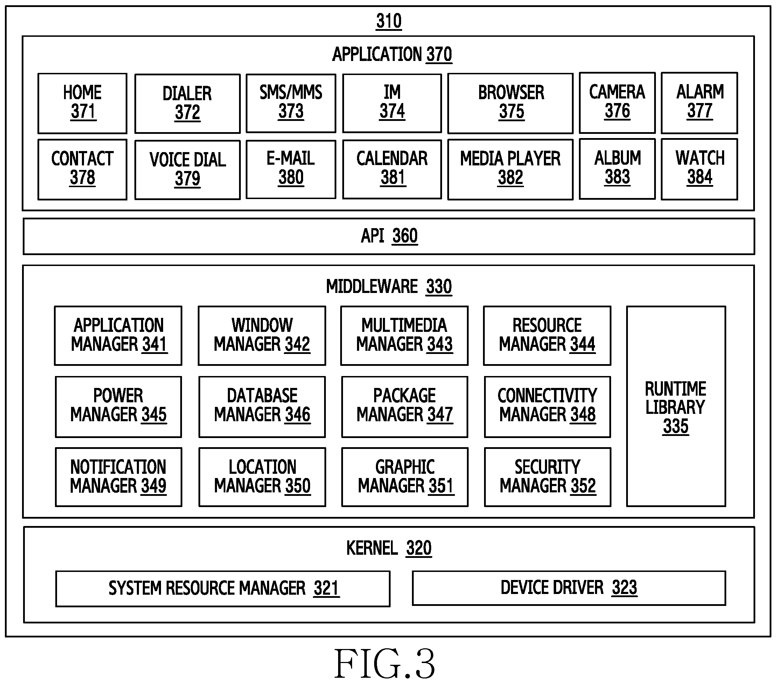

FIG. 3 illustrates a program module according to embodiments of the present disclosure. The program module 310 may include an OS controlling resources related to an electronic device such as the electronic 101 of FIG. 1 and/or various applications such as the applications 147 run on the operating system. The operating system may include Android™, iOS™, Windows™, Symbian™, Tizen™, or Bada™. Referring to FIG. 3, the program module 310 may include a kernel 320 such as the kernel 141 of FIG. 1 , middleware 330 such as the middleware 143 of FIG. 1 an API 360 such as the API 145 of FIG. 1 , and/or an applications 370 such as the applications 147 of FIG. 1. At least a part of the program module 310 may be preloaded onto an electronic device, or be downloaded from an external electronic device such as the electronic device 102, 104 or the server 106.

The kernel 320 may include a system resource manager 321 and/or a device driver 323. The system resource manager 321 may perform control of a system resource, allocation thereof, or recovery thereof and may include a process management unit, a memory management unit, or a file system management unit. The device driver 323 may include a display driver, a camera driver, a Bluetooth driver, a shared memory driver, a USB driver, a keypad driver, a WiFi driver, an audio driver, or an inter-process communication (IPC) driver. The middleware 330 may provide a function the applications 370 commonly need, or provide various functions to the applications 370 through the API 360 so that the applications 370 may utilize restricted system resources within an electronic device. The middleware 330 may include at least one of a runtime library 335, an application manager 341, a window manager 342, a multimedia manager 343, a resource manager 344, a power manager 345, a database manager 346, a package manager 347, a connectivity manager 348, a notification manager 349, a location manager 350, a graphic manager 351, and a security manager 352.

The runtime library 335 may include a library module a compiler uses to add a new function through a programming language while at least one of the applications 370 is executed. The runtime library 335 may perform input output management, memory management, or arithmetic function processing. The application manager 341 may manage a lifecycle of the applications 370. The window manager 342 may manage a GUI resource used for a screen. The multimedia manager 343 may detect a format required for playing media files, and perform encoding or decoding of the media file by using a codec suitable to the corresponding format. The resource manager 344 may manage a source code of the applications 370 or a space of a memory. The power manager 345 may manage a battery capacity or a power supply, and provide power information required for an operation of an electronic device. The power manager 345 may link with a basic input / output system (BIOS). The database manager 346 may create, search or change a database that will be used in the applications 370. The package manager 347 may manage installation or updating of an application that is distributed by a package file.

The connectivity manager 348 may manage wireless connectivity. The notification manager 349 may provide events such as an arrival message, an appointment, a proximity notification, etc. to a user. The location manager 350 may manage location information of an electronic device. The graphic manager 351 may manage a graphic effect that will be provided to a user, or a user interface related with this. The security manager 352 may provide system security or user authentication. The middleware 330 may include a telephony manager for managing a voice or video telephony function of the electronic device or a middleware module capable of forming a combination of functions of the aforementioned elements. The middleware 330 may provide a module that is specialized based on the type of an operating system. The middleware 330 may dynamically delete some of the existing elements or add new elements. The API 360 is a set of API programming functions, and may be provided to have another construction according to an operating system. For example, Android or iOS may provide one API set on a per-platform basis, and Tizen may provide two or more API sets on a per-platform basis.

The applications 370 may include a home 371, a dialer 372, a short message service (SMS)/multimedia message service (MMS) 373, an instant message (IM) 374, a browser 375, a camera 376, an alarm 377, a contact 378, a voice dial 379, an electronic mail (e-mail) 380, a calendar 381, a media player 382, an album 383, a watch 384, health care, such as for measuring momentum or blood sugar, or an environment information provision application, such as for measuring air pressure, humidity, or temperature. The applications 370 may include an information exchange application that may support information exchange between an electronic device and an external electronic device, such as a notification relay application for relaying specific information to the external electronic device, or a device management application for managing the external electronic device. For example, the notification relay application may relay, to the external electronic device, notification information generated from another application of the electronic device, or receive notification information from the external electronic device to provide the received notification information to a user. The device management application may install, delete, or update a function, such as turn-on/turn-off of the external electronic device itself or some components, or adjustment of a resolution of a display of the external electronic device that communicates with the electronic device, or an application operating in the external electronic device.

The applications 370 may include a health care application of a mobile medical instrument that is designated according to an attribute of the external electronic device, and may include an application received from the external electronic device. At least a part of the program module 310 may be executed by software, firmware, hardware, or a combination of at least two thereof, and may include a module for performing one or more functions, a program, a routine, sets of instructions or a process.

The term "module" used in the present disclosure may include a unit consisting of hardware, software, or firmware, and may be used interchangeably with the terms "logic", "logic block", "component", "circuit", may become an integrally configured component or the minimum unit performing one or more functions or a part thereof. and may be implemented mechanically or electronically and may include an application-specific integrated circuit (ASIC) chip, field-programmable gate arrays (FPGAs), or a programmable logic device, which have been known or will be developed in the future, performing some operations.

At least a part of an apparatus or method according to embodiments of the present disclosure may be implemented as an instruction that has been stored in a computer-readable storage media by a program module. When the instruction is executed by a processor, the processor may perform a function corresponding to the instruction. The computer-readable recording media may include a hard disc, a floppy disc, a magnetic media, such as a magnetic tape, an optical recording media, such as a compact disc - read only memory (CD-ROM) and/or a digital versatile disc (DVD), a magneto-optical media, such as a floptical disc, and an internal memory. The instruction may include a code that is made by a compiler or a code that is executable by an interpreter. The module or program module according to embodiments of the present disclosure may include at least one or more of the aforementioned elements, or omit some, or further include another element. Operations performed by the module, the program module or another element according to embodiments of the present disclosure may be executed in a sequential, parallel, repeated or heuristic manner, at least some operations may be executed in different order or be omitted, or another operation may be added.

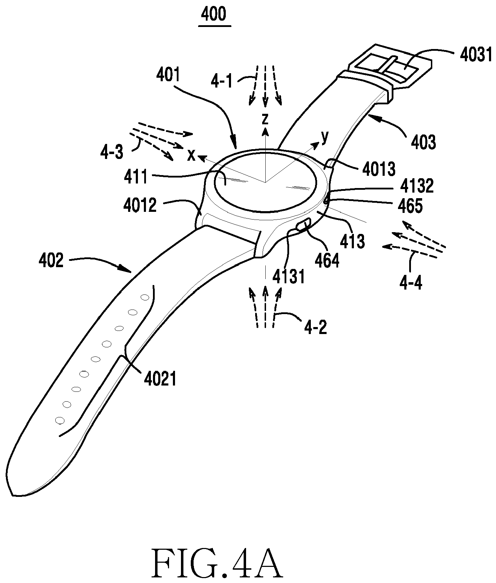

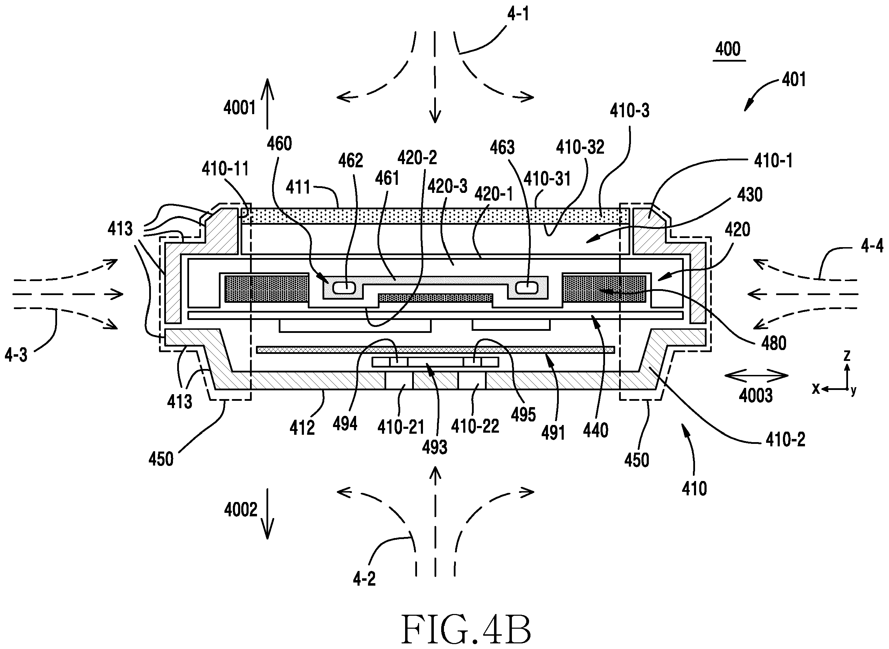

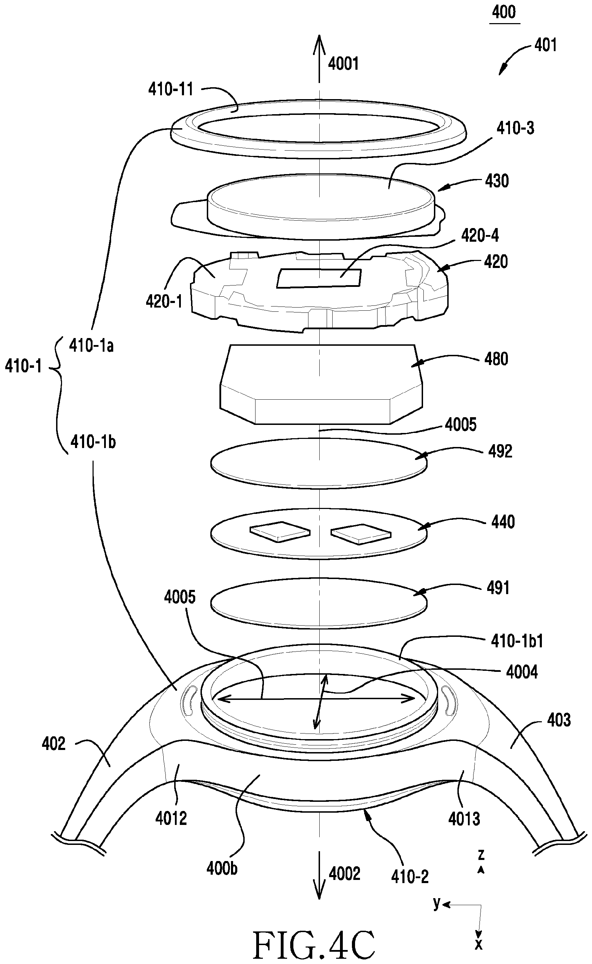

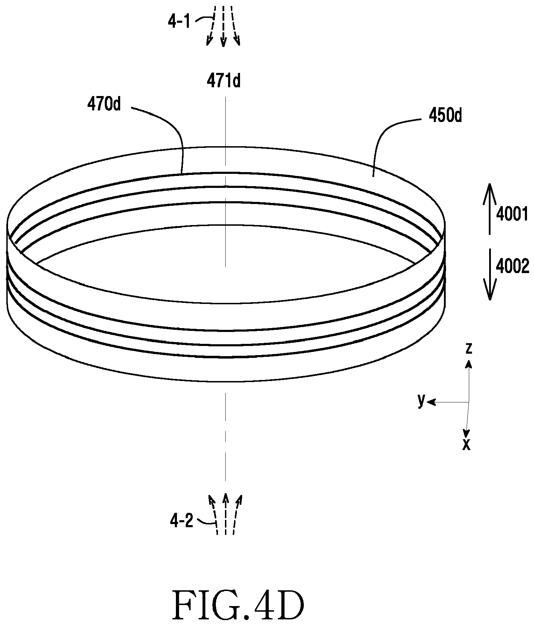

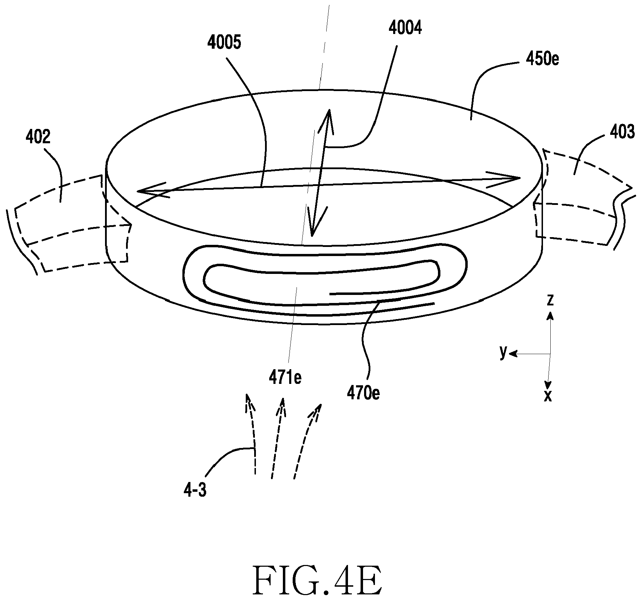

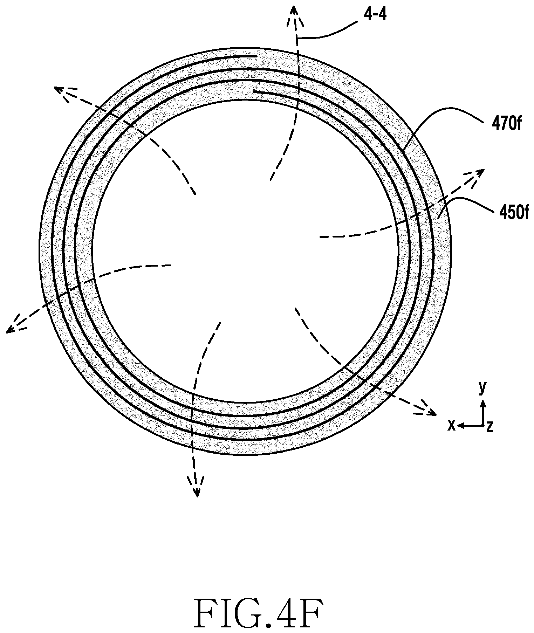

FIG. 4A illustrates an electronic device capable of performing wireless power transmission and/or reception according to an embodiment of the present disclosure. FIGS. 4B and 4C illustrate a relationship between elements of the electronic device capable of performing wireless power transmission and/or reception according to an embodiment of the present disclosure. FIGS. 4D, 4E and 4F illustrate an arrangement structure of an antenna according to an embodiment of the present disclosure. According to embodiments, the electronic device 400 may include at least some of the elements of the electronic device 101 of FIG. 1 or the electronic device 201 of FIG. 2.

The electronic device 400 may be a watch-type electronic device that may be worn on a user's wrist. The electronic device 400 may include a body 401 mounting various electronic components such as a processor, a memory, a display, a wireless power transmission and/or reception apparatus, and a first extension part 402 and a second extension part 403 connected to dual side end parts 4012 and 4013 of the body 401 for wrapping around the user's wrist when the electronic device 400 is worn on the user's wrist. The extension parts 402 and 403 may be formed with a band or a strap of various materials, such as leather, rubber, or metal, and may be designed to be mutually connectable in various schemes when the electronic device 400 is worn on the user's wrist. As illustrated in FIG. 4A, the first extension part 402 may include a majority of binding holes 4021 which are disposed along its extension length, the second extension part 403 may include, at its end part, a fastening device 4031 which is combinable to the first extension part 402 using the majority of binding holes 4021 of the first extension part 402.

The first extension part 402 may be connected to one end part 4012 of the body 401 by being rotatable centering on the one end part 4012 of the body 401. Likewise, the second extension part 403 may be connected to the other end part 4013 of the body 401 by being rotatable centering on the other end part 4013 of the body 401.

As illustrated in FIG. 4C, the first extension part 402 may be connected to the one end part 4012 of the body 401 by being supported by and shaped downward from the one end part 4012 of the body 401. Likewise, the second extension part 403 may be connected to the other end part 4013 of the body 401 by being supported by and shaped downward from the other end part 4013 of the body 401.

The body 401 includes an electromagnetic field circuit which is capable of wirelessly transmitting and/or receiving power. An electromagnetic field 4-1 from an external electronic device may be applied to the body 401 toward a first surface 411 via which a screen is exposed, and the body 401 may wirelessly receive power from the external electronic device. An electromagnetic field 4-2 from an external electronic device may be applied to the body 401 toward a second surface 412 facing in a direction opposite to the first surface 411 via which the screen is exposed, and the body 401 may wirelessly receive power from the external electronic device. An electromagnetic field 4-3 or 4-4 from an external electronic device may be applied to the body 401 toward a third surface 413, which surrounds a space between the first surface 411 and the second surface 412, and the body 401 may wirelessly receive power from the external electronic device.

Referring to FIG. 4B and 4C, the body 401 may include a housing 410, a bracket 420, a display 430, a printed circuit board (PCB) 440 and an antenna array region 450.

The housing 410 may form an appearance of the body 401 of the electronic device 400 and may include the first surface 411 facing in a first direction 4001, and the second surface 412 facing in a second direction 4002 that is opposite to the first surface 411. The housing 410 may include the third surface 413 of a roughly ring form surrounding a space between the first surface 411 and the second surface 412. If the electronic device 400 is worn on the user's wrist, the second surface 412 may come in contact with the user's wrist to cover the user's wrist, and the display 430 may be exposed through the first surface 411.

The first surface 411 and the second surface 412 may be roughly planes and in parallel with each other. According to another embodiment, the first surface 411 or the second surface 412 may be a curved surface that is convex in the first direction 4001 or the second direction 4002.

The housing 410 may include a first housing 410-1 that is a cover of a form that is roughly convex in the first direction 4001, and a second housing 410-2 that is a cover of a form that is roughly convex in the second direction 4002. If the first housing 410-1 and the second housing 410-2 are connected with each other, a space mounting various components may be provided.

The first housing 410-1 may include the first surface 411. The second housing 410-2 may include the second surface 412. The third surface 413 may be provided by at least one of the first housing 410-1 and the second housing 410-2. For example, the first housing 410-1 may include one portion of the third surface 413, and the second housing 410-2 may include the remnant portion of the third surface 413. When viewed from cross-section, the third surface 413 may be a form that is roughly convex outside the direction 4003 crossing at right angles to (i.e., perpendicular to) the first direction 4001 or the second direction 4002. According to embodiments, a portion of a ring form surrounding a space between the first surface 411 and the second surface 412 in the housing 410 may be referred to as a bezel 400b.

The first housing 410-1 may be a ring form including an opening 410-11. For example, as illustrated, the first housing 410-1 may be a roughly circular ring. According to another embodiment, the first housing 410-1 may be various ring forms such as an eclipse, a triangle, or a square. The display 430 may be exposed through the opening 410-11 of the first housing 410-1.

The first housing 410-1 may include a window 410-3 disposed in the opening 410-11 and including light transmittance materials. For example, the window 410-3 may be a plate of glass materials. When viewed in the second direction 4002, the window 410-3 is a shape combinable to the opening 410-11 of the first housing 410-1, and may be of a circular shape.

The window 410-3 may include an outer surface 410-31 facing in the first direction 4001 and an inner surface 410-32 facing in the second direction 4002. The outer surface 410-31 may include at least a part of the first surface 4001, and be a plane or curved surface. The inner surface 410-32 may be disposed inside the body 401, and be a plane.

Referring to FIG. 4C, the first housing 410-1 may include a first portion 410-1a of a circular ring form. The first housing 410-1 may include a second portion 410-1b of a roughly cylindrical form, and be disposed between the first portion 410-1a and the second housing 410-2. The second portion 410-1b may include a circular connection part 410-1b1 protruded in the first direction 4001. The first portion 410-1a may be combined to the connection part 410-1b1 of the second portion 410-1b. According to an embodiment, the first portion 410-1a may be designed to be rotatable when being combined to the connection part 410-1b1 of the second portion 410-1b.

The bracket (or mid-plate) 420 is disposed between the display 430 and the PCB 440. Various electronic components are mounted on bracket 420, and supported by the bracket 420. The display 430 and the PCB 440 may be supported by the bracket 420, to secure rigidity. The bracket 420 may also support and protect a battery 480.

The bracket 420 may include a first installation surface 420-1 supported as a portion capable of installing the display 430, and a second installation surface 420-2 supported as a portion capable of installing the PCB 440. The first installation surface 420-1 and second installation surface 420-2 of the bracket 420 may include a groove capable of mounting the display 430 and the PCB 440 without unwavering in supporting the display 430 and the PCB 440.

The bracket 420 is roughly a plate form, and may be disposed within the second portion 410-1b of the first housing 410-1. For example, the bracket 420 may be combined to a safely mounting part formed inside the second portion 410-1b of the first housing 410-1, using such means as a bolt fastened method.

According to embodiments, when viewed in the second direction 4002, the bracket 420 may be roughly a ring form including a through-hole part 420-4.

The display 430 may be disposed between the window 410-3 and the bracket 420. According to an embodiment, the display 430 may be combined to an inner surface 410-32 of the window 410-3. In some embodiments, the display 430 may be provided as a module including the window 410-3. The display 430 may be electrically connected to the PCB 440, and display an image according to an electric signal from the PCB 440. The display 430 may include an electrical connection means, such as flexible printed circuit board (FPCB) or cable, that is electrically connected to the PCB 440.

The display 430 may include an LCD, or an OLED, such as active matrix OLED (AMOLED).

The display 430 may further include a touch panel for a touch input and/or hovering input induced in the display 430 and forwarded to the PCB 440. According an embodiment, the display 430 may provide a display integral touch screen. For example, the display 430 may be an AMOLED integral touch screen, such as On-Cell TSP AMOLED (OCTA). In some embodiments, the display 430 may be designed as a wearable, flexible, or bendable display.

The body 401 may further include a pressure sensor including a conductive pattern and a detector electrically connected to the conductive pattern. The conductive pattern may include a first electrode and a second electrode that have been mutually isolated. The first electrode may be disposed to face an outer surface of the body 401, and the second electrode, such as the ground mounted on the body 401, may be disposed within the body 401 to be at least partially overlapped with the first electrode.

If the detector applies a voltage to the first electrode and the second electrode, induction of capacitance may be induced between the first electrode and the second electrode. If a pressure is applied to the outer surface of the body 401, a distance between the first electrode and the second electrode decreases, and the capacitance may change. The detector may output a signal according to this change of the capacitance, to a processor of the body 401, which may sense a position in which the pressure has been applied among the outer surface of the body 401.

The conductive pattern of the pressure sensor may be disposed along at least a part of the outer surface of the body 401 or the display 430. For example, the conductive pattern of the pressure sensor may be designed as an integral type with a conductive pattern for the touch input or hovering input, and may be disposed between the conductive pattern for the touch input or hovering input and the window 410-3. According to some embodiment, the conductive pattern of the pressure sensor may be disposed in an in-cell region or on-cell region of the display 430.

The PCB 440 may be disposed between the bracket 420 and the second surface 412. The PCB 440 may include a majority of electronic components and an electrical line connecting the electronic components. The PCB 440 may set an execution environment of the electronic device 400, and keep information thereof, and support data input and/or output exchange of devices within the electronic device 400.

The PCB 440 may include an electromagnetic field circuit which may wirelessly transmit and/or receive a signal or power, using at least one antenna included in the electronic device 400. The electromagnetic field circuit may include a power transmission and/or reception circuit and a communication circuit.

The power transmission and/or reception circuit of the PCB 440 may wirelessly receive or transmit power using at least one antenna of the antenna array region 450. The power transmission and/or reception circuit may include a power transmission and/or reception circuit of a magnetic induction scheme. For example, if an electromagnetic field flowing in an antenna such as a coil of an external electronic device is applied to at least one antenna of the antenna array region 450, an induced current flows in at least a part of the at least one antenna and by using this induced current, the power transmission and/or reception circuit may provide power to a load of the electronic device 400, such as by battery charging. In some embodiments, the power transmission and/or reception circuit may wirelessly transmit power to the external electronic device, using magnetic induction between the antenna of the external electronic device and the at least one antenna of the antenna array region 450.

The power transmission and/or reception circuit of the PCB 440 may include a power transmission and/or reception circuit of a magnetic resonance scheme. For example, at least a part of at least one antenna of the antenna array region 450 and a power transmitting antenna of an external electronic device may have the same resonance frequency. By using a resonance phenomenon between the at least one part and the power transmitting antenna, the power transmission and/or reception circuit may receive power from the external electronic device, or transmit power to the external electronic device.

The communication circuit of the PCB 440 may support communication of various forms that use at least one antenna of the antenna array region 450, may include a short-range communication circuit, and may support short-range communication with an external electronic device using the at least one antenna of the antenna array region 450. For example, the short-range communication may include WiFi, BT, NFC, or GNSS. In an embodiment, the short-range communication may include magnetic signal transmission and/or reception, such as MST for electronic payment, with the external electronic device. The magnetic signal transmission and/or reception technology for off-line payment using a magnetic field, may be used for performing communication with a POS device.

The communication circuit of the PCB 440 may include a cellular communication circuit, and may transmit a mobile communication signal to a base station or receive such a signal from the base station, using at least one antenna of the antennary array region 450.

The antenna array region 450, a portion including at least one antenna, may surround a space between the first surface 411 and the second surface 412 according to an embodiment of the present disclosure.

According an embodiment, when viewed in the second direction 4002, at least one antenna may be disposed in a portion of the antenna array region 450 surrounding an edge region of the window 410-3.

According to another embodiment, when viewed in the second direction 4002, at least one antenna may be disposed in a portion of the antenna array region 450 surrounding an edge region of the display 430.

In some embodiments, when viewed in the second direction 4002, at least one antenna may be disposed in a portion of the antenna array region 450 surrounding an edge region of the bracket 413, in an edge region of a ring form of the bracket 420, or be included in the edge region of the ring form of the bracket 420.

In some embodiments, when viewed in the second direction 4002, at least one antenna may be disposed in a portion of the antenna array region 450 surrounding an edge region of the PCB 440, in an edge region of a ring form of the PCB 440, or be included in the edge region of the ring form of the PCB 440.

According to an embodiment, at least one antenna may be disposed in an inner surface of a portion, such as the bezel 400b, of a ring form forming the third surface 413 in the housing 410. For example, the inner surface of the bezel 400b of the housing 410 may include conductive materials, and the at least one antenna may be molded using laser cutting processing.

According to embodiments, at least one antenna may be disposed within the bezel 400b of the housing 410. For example, the at least one antenna may be molded in a similar scheme with an inmolding antenna (IMA), or through double injection. For example, the at least one antenna may be disposed in a scheme of being inserted into an injection mold.

According to embodiments, at least one antenna may be molded through a sheet metal, such as a steel use stainless (sus) sheet metal, through laser direct structuring (LDS).

According to an embodiment, at least one antenna may be formed a film, such as an indium tin oxide (ITO) film, or FPCB.

At least one antenna may be molded through other molding methods.

At least one antenna of the antenna array region 450 may include a conductive line that has been extended from a first end part to a second end part to form a wound portion of a plurality of turns, such as in a coil-shaped or a ring-shaped metal pattern.

At least one antenna of the antenna array region 450 may be a coil-shaped metal pattern that is roughly similar to a coil-shaped spring having a plurality of turns and having a height of the first direction 4001. For example, referring to FIG. 4D, a coil-shaped metal pattern 470d may include a plurality of turns of a clockwise direction or counterclockwise direction centering on an axis 471d of the first direction 4001 or second direction 4002, along a cylindrical surface 450d of a ring form according to the third surface 413 of the housing 410. The axis 471d may be a central axis of the inside space of the cylindrical surface 440d. If an electromagnetic field 4-1 from an external electronic device is applied to the coil-shaped metal pattern 470d roughly in the second direction 4002, or an electromagnetic field 4-2 from an external electronic device is applied to the coil-shaped metal pattern 470d roughly in the first direction 4001, an induced current may flow in the coil-shaped metal pattern 470d by magnetic induction.

Referring to FIG. 4E according to another embodiment, a coil-shaped metal pattern 470e may include a plurality of turns that are formed in a partial region of a cylindrical surface 450e of a ring form according to the third surface 413. A region where the plurality of turns is formed may include a portion where the first extension part 402 and the second extension part 403 are not disposed in a bezel 400b. The coil-shaped metal pattern 470e may be wound in a clockwise direction or counterclockwise direction centering on an axis 471e of a direction 4004 crossing at right angles to (i.e., perpendicular to) a direction 4005 between the first extension part 402 and the second extension part 403. Referring back to FIGs. 4B and 4C, the direction 4003 may be radical directions perpendicular to the direction 4001 or 4002, and the direction 4004 or 4005 may be one among the radical directions. If an electromagnetic field 4-3 from an external electronic device is applied to the coil-shaped metal pattern 470e roughly in the direction 4004, an induced current may flow in the coil-shaped metal pattern 470e by magnetic induction.

The surfaces 450d and 450e of the ring form of FIGS. 4D and 4E may be combined to an inner surface of the housing 410, or be a part of the housing 410.

At least one antenna 470f of the antenna array region 450 may be a coil-shaped metal pattern of a plate form that includes a plurality of turns disposed along the third surface 413, and disposed on a surface 450f being roughly in parallel with the first surface 411 or second surface 412. If an electromagnetic field 4-4 from an external electronic device is applied to the coil-shaped metal pattern 470f roughly in a first direction 4001 or second direction 4002, an induced current may flow in the coil-shaped metal pattern 470f by magnetic induction.

If an antenna of an external electronic device is disposed at the side of the first surface 411, and is aligned to at least one antenna 470d or 470f of the antenna array region 450, the electromagnetic field 4-1 flowing in the antenna of the external electronic device is applied to the at least one antenna through the first surface 411, and an induced current may flow in the at least one antenna. If the antenna of the external electronic device is disposed at the side of the second surface 412 and is aligned to the at least one antenna of the antenna array region 450, the electromagnetic field 4-2 flowing in the antenna of the external electronic device is applied to the at least one antenna through the second surface 412, and an induced current may flow in the at least one antenna. By using this induced current, an electromagnetic field circuit of the PCB 440 may provide power to a load of the electronic device 400, such as by battery charging. In some embodiments, the electromagnetic field circuit of the PCB 440 may wirelessly transmit power to the external electronic device using magnetic induction between the antenna of the external electronic device and the antenna of the electronic device 400. If the antenna of the external electronic device is disposed at the side of the third surface 413 and is aligned to the at least one antenna 470e of the antenna array region 450, the electromagnetic field 4-3 flowing in the antenna of the external electronic device is applied to the at least one antenna through the third surface 413, and an induced current may flow in the at least one antenna. By using this induced current, the electromagnetic field circuit of the PCB 440 may provide power to a load of the electronic device 400, such as by battery charging.

According to embodiments, at least one antenna of the antenna array region 450 may be used for power transmission and/or reception of a magnetic resonance scheme. In some embodiments, at least one antenna of the antenna array region 450 may be used for communication of various forms, such as short-range communication.

The body 401 may further include at least one electrical shield member which may prevent a malfunction or damage of electronic components of the PCB 440, caused by an electromagnetic field originating from an external electronic device. For example, when the electromagnetic field from the external electronic device is applied to at least one electronic component (or metal materials) within the body 401, electromotive force is generated by the change of a magnetic flux, and an eddy current generated by this electromotive force may cause a problem of a power loss in wireless power reception, or a malfunction or temperature increase of at least one electronic component. To reduce the occurrence of this problem, the electrical shield member may shield the flow of this eddy current.

The electrical shield member may be the form of a metal plate or metal layer that roughly crosses at right angles to a first direction 4001 or second direction 4002 of an electromagnetic field 4-1 or 4-2 originating from an external electronic device, and may include a ferrite sheet.

The electrical shield member may be disposed by being surrounded by a coil for power transmission and/or reception, such as the coil-shaped metal pattern 470e. For example, the electrical shield member may be a circular conductive plate having the same diameter as a circular coil for power transmission and/or reception, but may also be various other forms surrounded by the coil for power transmission and/or reception.

The electrical shield member may be a circular conductive plate having a center line 4005 matched with a virtual center line 471 d of the circular coil.

According to an embodiment, one electrical shield member 491 may be disposed between the second surface 412 and the PCB 440. In addition, another electrical shield member 492 may be disposed between the battery 480 and the PCB 440, and/or may be disposed between the display 430 and the bracket 420, and between the bracket 420 and the battery 480, for example.

The body 401 may include the battery 480 for supplying power required for driving of the electronic device 400. The battery 480 may be disposed between the bracket 420 and the PCB 440. According to an embodiment, the battery 480 may be disposed in a groove provided in the second surface 420-2 of the bracket 420. According to an embodiment, power wirelessly received from an external electronic device through at least one antenna of the antenna array region 450 may be used for charging the battery 480.

The body 401 may further include at least one sensor 493 which is disposed between the electrical shield member 491 and the second surface 412. According to an embodiment, the at least one sensor 493 may include a sensor capable of detecting an optical signal of at least one wavelength band. For example, the at least one sensor 493 may include a light emitting unit 494, such as an LED, capable of generating light of at least one wavelength band and a light receiving unit 495, such as a photo diode, capable of detecting an optical signal of at least one wavelength band.

The second housing 410-2 may include a first through-hole 410-21 and a second through-hole 410-22. Light from the light emitting unit 494 may be discharged out through the first through-hole 410-21. External light may be forwarded to the light receiving unit 495 through the second through-hole 410-22.

According to embodiments, the at least one sensor 493 may include one or more light emitting units and/or light receiving units, and thus, one or more through-holes of the second housing 410-2 may be provided. For example, the at least one sensor 493 may include two light emitting units and one light receiving unit. When viewed in the first direction 4001, the one light receiving unit may be disposed between the two light emitting units. In some embodiments, the at least one sensor 493 may be designed to include two light emitting units and one light receiving unit, and the second housing 410-2 may include three through-holes corresponding to the two light emitting units and one light receiving unit of the at least one sensor 493.

According to embodiments, a structure in which the second housing 410-2 includes one through-hole, and the light emitting unit 494 and light receiving unit 495 of the at least one sensor 493 share the one through-hole is also available.

The at least one sensor 493 may include a medical detection sensor. For example, when the electronic device 400 is worn on a user's wrist, light from the light emitting unit 494 may be forwarded to the user's wrist, and light reflected from the wrist may be forwarded to the light receiving unit 495, which may detect an optical signal and generate an electrical signal related to a heart rate.

The body 401 may further include input devices 460 of various forms disposed in the bracket 420 and including an FPCB 461, and at least one dome switch disposed on the FPCB 461. For example, the input device 460 may include a first dome switch 462 and a second dome switch 463. The body 401 may include a first through-hole 4131 and a second through-hole 4132 that are provided in the housing 410, and a first button 464 and a second button 465 that are disposed in the first through-hole 4131 and the second through-hole 4132 respectively. If the first button 464 is pressed, the first dome switch 462 may be electrically conducted. If the second button 465 is pressed, the second dome switch 463 may be electrically conducted. One end part of the FPCB 461 of the input device 460 may be extended to and electrically connected to the PCB 440.

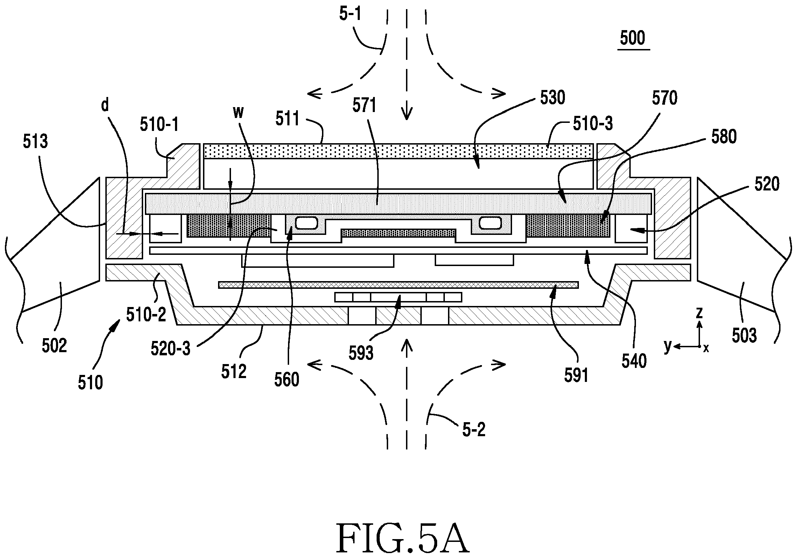

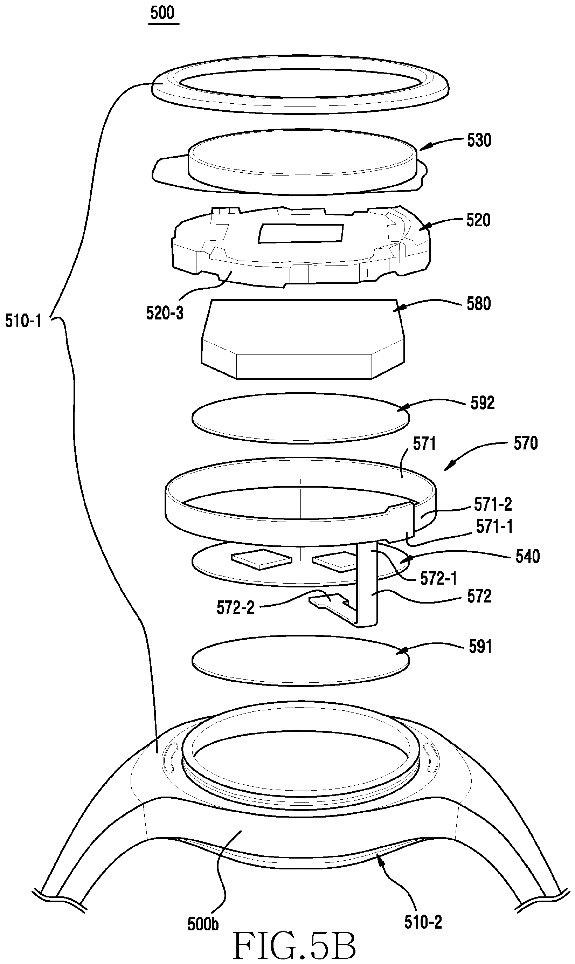

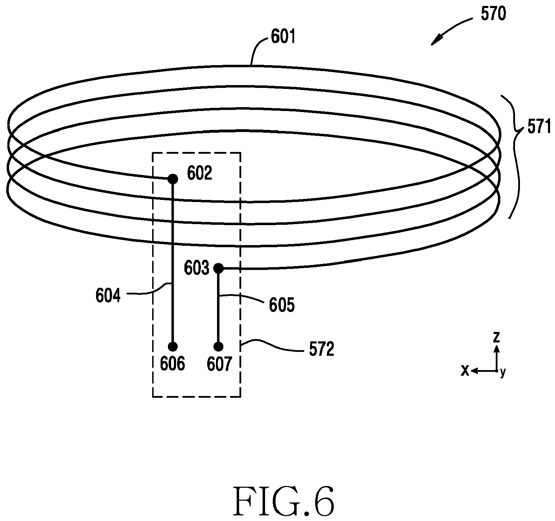

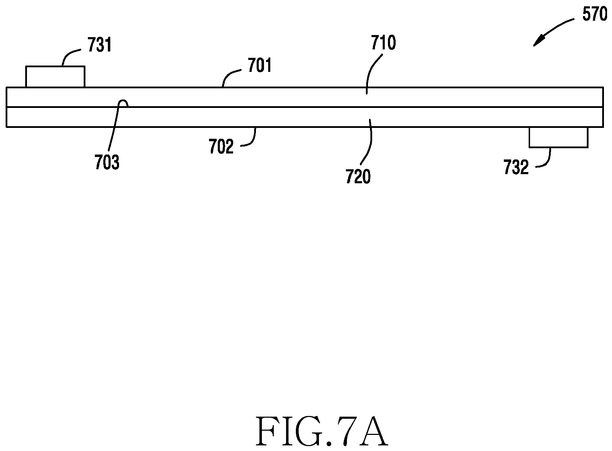

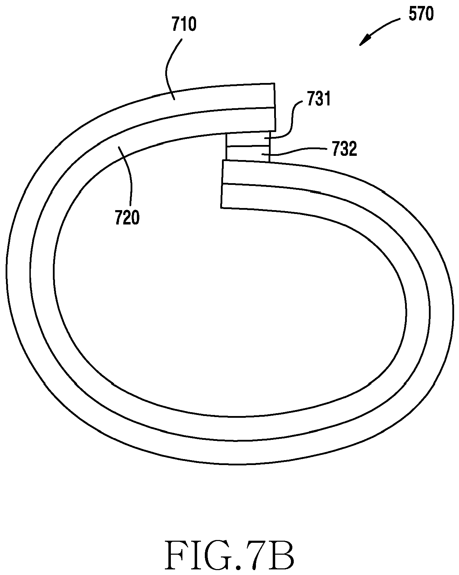

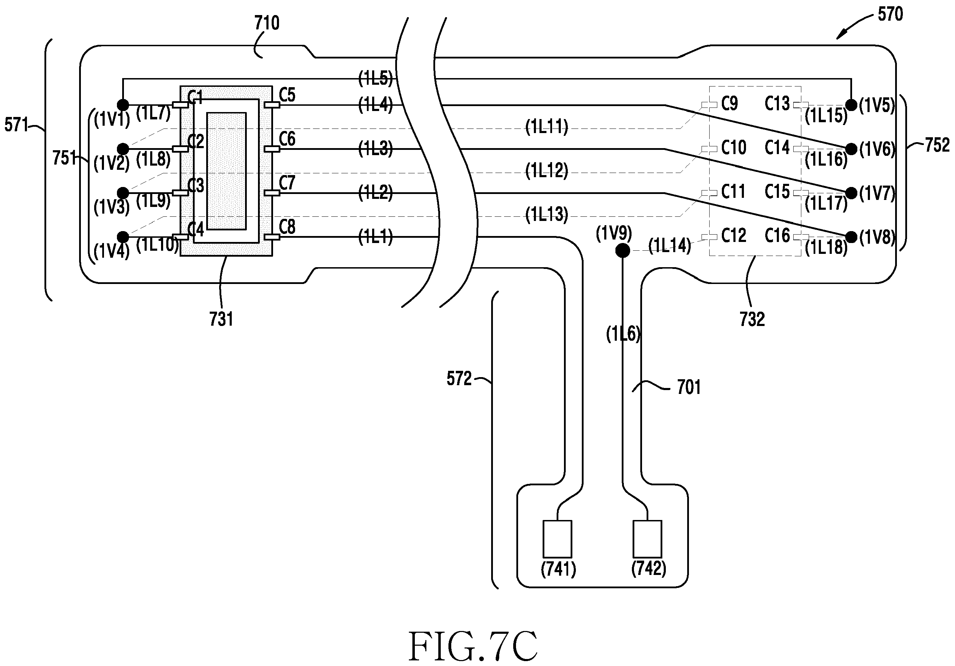

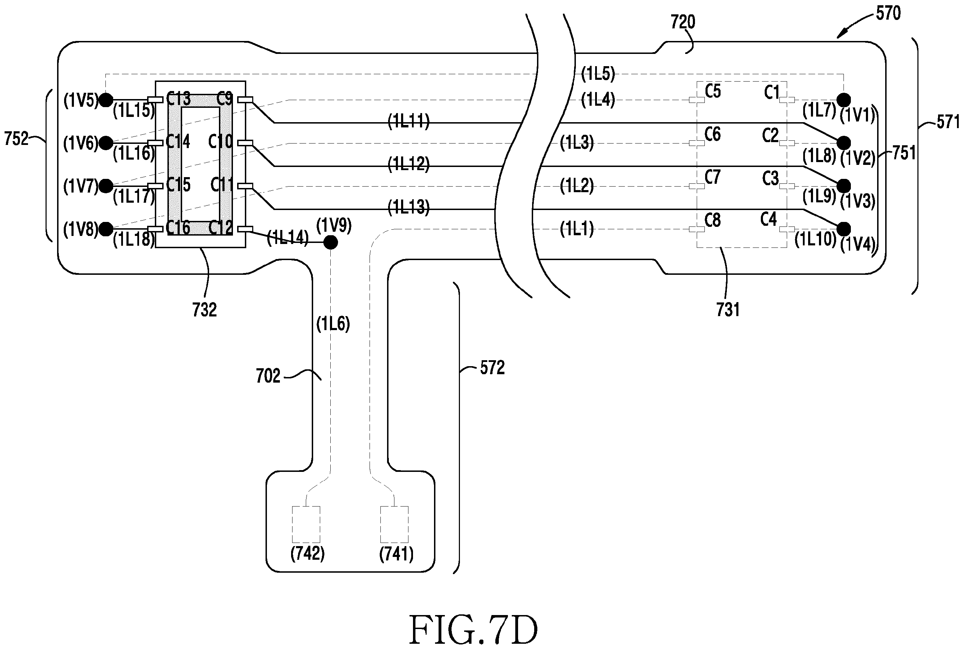

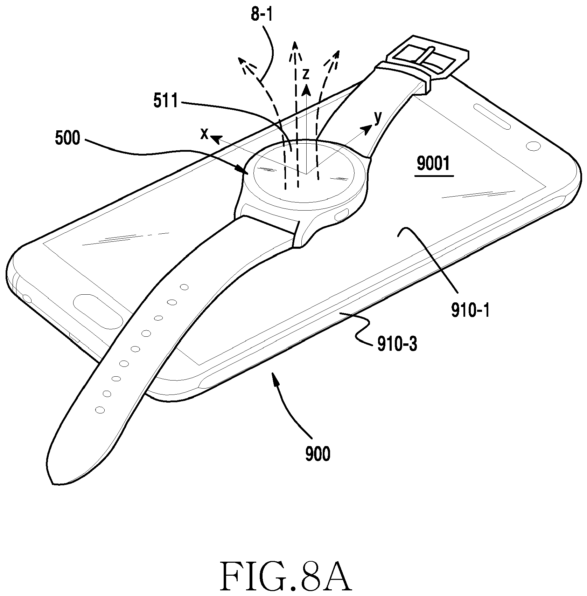

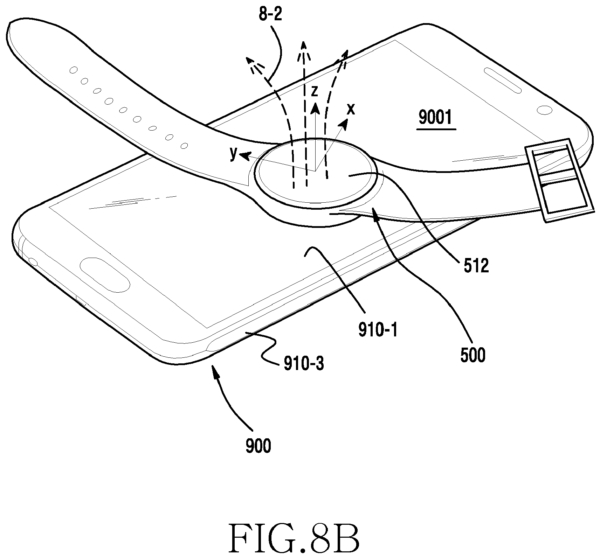

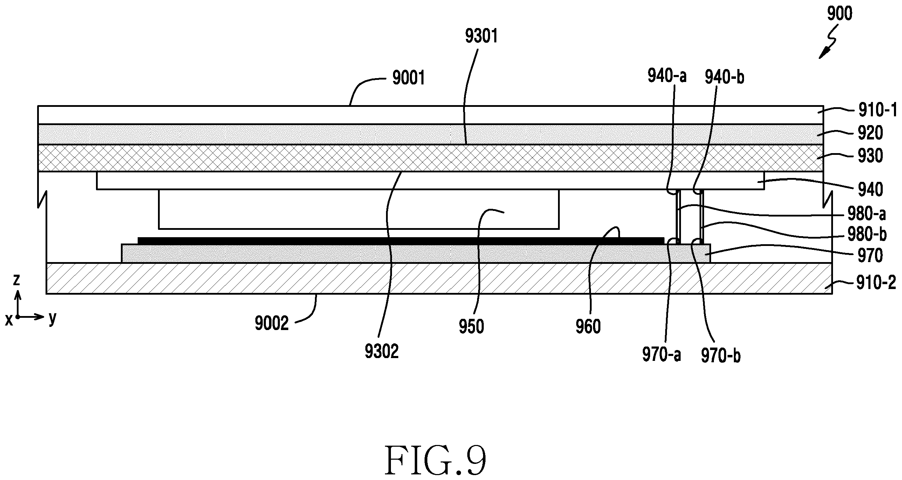

FIGS. 5A and 5B illustrate a structure of an electronic device capable of performing wireless power transmission and/or reception according to an embodiment of the present disclosure. FIG. 6 illustrates an antenna according to an embodiment of the present disclosure. FIGS. 7A, 7B, 7C and 7D illustrate a wiring structure of the antenna according to an embodiment of the present disclosure. FIGS. 8A and 8B illustrate wireless power transmission and/or reception between an electronic device and an external electronic device according to an embodiment of the present disclosure. FIG. 9 illustrates a structure of an external electronic device capable of performing wireless power transmission and/or reception according to an embodiment of the present disclosure.

The electronic device 500 may include a housing 510 having a first housing 510-1 and a second housing 510-2, a first extension part 502, a second extension part 503, a window 510-3, a bracket 520, a display 530, a PCB 540, an input device 560, electrical shield members 591 and 592, a battery 580, and at least one sensor 593, which are all similar to the above-described elements of the housing 410 of FIGS. 4B and 4C, respectively. Therefore, a detailed description thereof is omitted.

The electronic device 500 may include an antenna 570 that is disposed in a portion surrounding a space between a first surface 511 and a second surface 512. The antenna 570 may include a first extension part 571 extended from a first end part 571-1 to a second end part 571-2. If the first end part 571-1 and the second end part 571-2 are combined with each other, the first extension part 571 may become a ring shape, and the first end part 571-1 and the second end part 571-2 may be electrically connected with each other. For example, the first end part 571-1 may include a male connector, and the second end part 571-2 may include a female connector.

The first extension part 571 of the antenna 570 may be disposed on an inner surface of a bezel 500b of a ring form providing a third surface 513 in the housing 510. As illustrated, the first extension part 571 of the antenna 570 may surround the bracket 520.

The first extension part 571 may have a thickness equal to or less than a distance (d) between the bracket 520 and an inner side of the housing 510. The thickness of the first extension part 571 may or may not be roughly uniform.

The first extension part 571 may have a width (w) capable of at least partially surrounding a side of the bracket 520 and extendable to surround the PCB 540. In some embodiments, the width (w) of the first extension part 571 may be extendable to surround the electrical shield member 591.

The antenna 570 may include the second extension part 572 that is extended from the first extension part 571. One end part 572-1 of the second extension part 572 may be electrically connected to the first extension part 571, and the other end part 572-2 of the second extension part 572 may be electrically connected to the PCB 540. According an embodiment, the other end part 572-2 of the second extension part 572 may include a connector or a contact for electrical connection with the PCB 540.

The antenna 570 may include a conductive line that extends from a first end part to a second end part and includes a plurality of turns. For example, the antenna 570 may be a coil-shaped metal pattern that is roughly similar to a coil spring having a plurality of turns and having a height of a direction extending from the second surface 512 to the first surface 511.

Referring to FIG. 6, the first extension part 571 of the antenna 570 may include a first conductive line 601 including a plurality of turns, and the second extension part 572 of the antenna 570 may include a 2-1 conductive line 604 that connects one end part 602 of the first conductive line 601 and a first contact 606. The second extension part 572 of the antenna 570 may include a 2-2 conductive line 605 that connects the other end part 603 of the first conductive line 601 and a second contact 605. The first contact 606 and the second contact 607 may be electrically connected to a PCB, such as PCB 540 of FIG. 5.

The antenna 570 may be molded in a flexible film form as a flexible film antenna and may include a multi-layer. Referring to FIGS. 7A, 7B, 7C and 7D, the flexible film antenna 570 may include a first layer 710 and a second layer 720, and dual side surfaces 701 of the first layer 710 and 702 of the second layer 720, and a junction surface 703 of the first layer 710 and second layer 720 may be disposed between the dual side surfaces 701 and 702.

The flexible film antenna 570 may include a first connector 731, such as a socket connector that is disposed on the surface 701 of the first layer 710, and a second connector 732, such as a header connector that is disposed on the surface 702 of the second layer 720. The first connector 731 may be disposed at one end part of the flexible film antenna 570, and the second connector 732 may be disposed at the other end part of the flexible film antenna 570. Referring to FIG. 7B, if the first connector 731 and the second connector 732 are connected with each other, the flexible film antenna 570 may be deformed into a ring shape.

The first layer 710 may include a majority of conductive lines electrically connected to the first connector 731. The second layer 720 may include a majority of conductive lines electrically connected to the second connector 732. If the first connector 731 and the second connector 732 are connected with each other, the majority of conductive lines of the first layer 710 and second layer 720 may be, as in FIG. 6, formed as a single coil-shaped conductive line, which includes a plurality of turns of a form extended from a first end part to a second end part.

Referring to FIGS. 7C and 7D, the flexible film antenna 570 may include a first via set (or group) 751 formed at one end part (e.g., a left end part) of the first extension part 571 including a first via (1V1), a second via (1V2), a third via (1V3) and a fourth via (1 V4), and a second via set 752 formed at the other end part (e.g., a right end part) of the first extension part 571 including a fifth via (1V5), a sixth via (1V6), a seventh via (1V7) and an eighth via (1V8). When viewed in an unfolded state of the flexible film antenna 570, the first connector 731 and the second connector 732 may be disposed between the first via set 751 and the second via set 752. The flexible film antenna 570 may include a ninth via (1V9) formed near a connection part between the first extension part 571 and the second extension part 572.

The first connector 731 may include a first contact (C1), a second contact (C2), a third contact (C3) and a fourth contact (C4), which are arranged at one side of the first connector 731, and a fifth contact (C5), a sixth contact (C6), a seventh contact (C7) and an eighth contact (C8), which are arranged at the other side of the first connector 731. The first layer 710 may include an input contact 741 and an output contact 742, which are disposed on the surface 701 of an end part side of the second extension part 572. The first layer 710 may include a first conductive line (1L1) connecting the input contact 741 and the eighth contact (C8), a second conductive line (1L2) connecting the seventh contact (C7) and the eighth via (1V8), a third conductive line (1L3) connecting the sixth contact (C6) and the seventh via (1V7), a fourth conductive line (1L4) connecting the fifth contact (C5) and the sixth via (1V6), a fifth conductive line (1L5) connecting the first via (1V1) and the fifth via (1V5), and a sixth conductive line (1L6) connecting the output contact 742 and the ninth via (1V9). The first layer 710 may include a seventh conductive line (1L7) connecting the first via (1V1) and the first contact (C1), an eighth conductive line (1L8) connecting the second via (1V2) and the second contact (C2), a ninth conductive line (1L9) connecting the third via (1V3) and the third contact (C3), and a tenth conductive line (1L10) connecting the fourth via (1V4) and the fourth contact (C4).

The second connector 732 may include a ninth contact (C9), a tenth contact (C10), an eleventh contact (C11) and a twelfth contact (C12), which are arranged at one side of the second connector 732, and a thirteenth contact (C13), a fourteenth contact (C14), a fifteenth contact (C15) and a sixteenth contact (C16), which are arranged at the other side of the second connector 732.

The second layer 720 may include an eleventh conductive line (1L11) connecting the second via (1V2) and the ninth contact (C9), a twelfth conductive line (1L12) connecting the third via (1V3) and the tenth contact (C10), a thirteenth conductive line (1L13) connecting the fourth via (1V4) and the eleventh contact (C11), a fourteenth conductive line (1L14) connecting the ninth via (1V9) and the twelfth contact (C12), a fifteenth conductive line (1L15) connecting the thirteenth contact (C13) and the fifth via (1V5), a sixteenth conductive line (1L16) connecting the fourteenth contact (C14) and the sixth via (1V6), a seventeenth conductive line (1L17) connecting the fifteenth contact (C15) and the seventh via (1V7), and an eighteenth conductive line (1L18) connecting the sixteenth contact (C16) and the eighth via (1V8).

If the first connector 731 and the second connector 732 are connected with each other, a majority of conductive lines of the first layer 710 and the second layer 720 may be electrically connected with one another and, as in FIG. 6, a single coil-shaped conductive line including a plurality of turns of a form extended from a first end part 741 to a second end part 742 may be formed. The input and output contacts 741 and 742 of the second extension part 572 may be electrically connected to the PCB 540, and the single coil-shaped conductive line may be used as a wireless power transmitting and/or receiving antenna for wirelessly receiving power from an external electronic device, such as the electronic device 102 of FIG. 1, or transmitting power to the external electronic device.

For example, if the first connector 731 and the second connector 732 are connected with each other, the contacts (C1, C2, C3, C4, C5, C6, C7, and C8) of the first contact 731 may be electrically connected to the contacts (C9, C10, C11, C12, C13, C14, C15, and C16) of the second connector 732, respectively.

For example, if the first connector 731 and the second connector 732 are connected with each other, the first conductive line (1L1) may be electrically connected to the second conductive line (1L2), due to connection of the eighth contact (C8) and the sixteenth contact (C16) and connection of the sixteenth contact (C16) and the eighth via (1V8). In this connection scheme, electrical connection may be made between the second conductive line (1L2) and the third conductive line (1L3), the third conductive line (1L3) and the fourth conductive line (1L4), and the fourth conductive line (1L4) and the fifth conductive line (1L5).

For example, if the first connector 731 and the second connector 732 are connected with each other, the fourth conductive line (1L4) may be electrically connected to the fifth conductive line (1L5), due to connection of the fifth contact (C5) and the thirteenth contact (C13) and connection of the thirteenth contact (C13) and the fifth via (1V5).

For example, if the first connector 731 and the second connector 732 are connected with each other, the fifth conductive line (1L5) may be electrically connected to the eleventh conductive line (1L11), due to connection of the first via (1V1) and the first contact (C1) and connection of the first contact (C1) and the ninth contact (C9). In this connection scheme, electrical connection may be made between the eleventh conductive line (IL11) and the twelfth conductive line (1L12), and the twelfth conductive line (1L12) and the thirteenth conductive line (IL13). The fourteenth conductive line (1L14) may be electrically connected to the sixth conductive line (1L6) by the ninth via (1V9).

A form of the flexible film antenna 570 and the elements thereof in FIGS. 7C and 7D may vary. For example, the contacts or conductive lines of the first and/or second connectors 731 and/or 732 may be changed in number and position, and a coil-shaped conductive line including a plurality of turns of various forms may also vary.

The flexible film antenna 570 may be molded into various forms and into an FPCB according to the present disclosure.

Referring back to FIG. 5A, the PCB 540 may include a power transmission and/or reception circuit, and may wirelessly receive or transmit power using the antenna 570. The power transmission and/or reception circuit may be of a magnetic induction scheme. If an antenna of an external electronic device is disposed at a first surface 511 side and is aligned to the antenna 570, an electromagnetic field 5-1 flowing in the antenna of the external electronic device may be applied to the antenna 570 through the first surface 511, and an induced current may flow in the antenna 570. If the antenna of the external electronic device is disposed at a second surface 512 side and is aligned to the antenna 570, an electromagnetic field 5-2 flowing in the antenna of the external electronic device may be applied to the antenna 570 through the second surface 512, and an induced current may flow in the antenna 570. By using this induced current, the power transmission and/or reception circuit of the PCB 540 may provide power to a load of the electronic device 500. The power transmission and/or reception circuit of the PCB 540 may wirelessly transmit power to the external electronic device using magnetic induction between the antenna of the external electronic device and the antenna 570 of the electronic device 500.

The power transmission and/or reception circuit of the PCB 540 may be a magnetic resonance scheme. For example, at least a part of the antenna 570 and a power transmitting antenna of the external electronic device may have the same resonance frequency and, by using a resonance phenomenon between the part of the antenna 570 and the power transmitting antenna, the power transmission and/or reception circuit of the PCB 540 may receive power from, or transmit power to, the external electronic device.

The PCB 540 may include a communication circuit, and may support communication of various forms that use the antenna 570.

Referring to FIGS. 8A, 8B and 9, an external electronic device 900 may include a first surface 9001 facing in a first direction, a second surface 9002 facing in a second direction that is opposite to the first direction, various elements disposed between the first surface 9001 and the second surface 9002, a first cover 910-1, a display 920, a bracket 930, a PCB 940, a battery 950, at least one coil-shaped metal pattern 970, and a second cover 910-2.

The first cover 910-1 may be roughly a plate shape and include a plastic or glass having impact resistance, and may be combined to a bezel 910-3, and form the first surface 9001 of the external electronic device 900.

The display 920 may be disposed between the first cover 910-1 and the bracket 930, and may be combined to the first cover 910-1. A screen region of the display 920 may be exposed to the external through the first cover 910-1.

The display 920 may display, as an image, an electrical signal provided from the PCB 940 and may include an LCD), an OLED or an AMOLED), and a conductive pattern for a touch input or hovering input. For example, the conductive pattern may be disposed in an in-cell region or on-cell region of the display 920. The display 920 may include a display integral touch screen, such as an on-cell touch screen panel AMOLED (OCTA).

The bracket 930 may be disposed between the display 920 and the PCB 940, may be combined to the bezel 910-3, and may include a first surface 9301 capable of housing the display 920 and a second surface 9302 capable of housing the PCB 940.

The PCB 940 may be configured to mount and electrically connect a plurality of electronic components, may set an execution environment and maintain information of the external electronic device 900, and may support data input/output exchange of devices within the external electronic device 900. The PCB 940 may include a power transmission and/or reception circuit for receiving and/or transmitting power using at least one conductive pattern mounted on the external electronic device 900, and a communication circuit for receiving and/or transmitting a signal on communication of various forms using at least one conductive pattern mounted on the external electronic device 900.

The battery 950 may be disposed between the bracket 930 and at least one coil-shaped metal pattern 970.

The at least one coil-shaped metal pattern 970 may be disposed on a plane between the first surface 9001 and the second surface 9002, which may be disposed to be roughly in parallel with the first surface 9001 and the second surface 9002.

The at least one coil-shaped metal pattern 970 may be disposed between the battery 950 and the second surface 9002. According to an embodiment, the least one coil-shaped metal pattern 970 may be disposed on the second cover 910-2, or may be included in the second cover 910-2.

The at least one coil-shaped metal pattern 970 may include a conductive line, which has been extended from a first end part to a second end part to form a wound portion of a plurality of turns, and may be electrically connected to the PCB 940. According to an embodiment, the at least one coil-shaped metal pattern 970 may include a first contact 970-a and second contact 970-b for electrically connecting with the PCB 940. The first contact 970-a may be positioned at or near the first end part of the conductive line, and the second contact 970-b may be positioned at or near the second end part of the conductive line. The PCB 940 may include a first contact 940-a and second contact 940-b for electrically connecting with the at least one coil-shaped metal pattern 970. When the PCB 940 and the at least one coil-shaped metal pattern 970 are installed in the external electronic device 900, the first contact 970-a of the at least one coil-shaped metal pattern 970 may be electrically connected to the first contact 940-a of the PCB 940, and the second contact 970-b of the at least one coil-shaped metal pattern 970 may be electrically connected to the second contact 940-b of the PCB 940.

According to an embodiment, the first contact 940-a and the second contact 940-b of the PCB 940 may be electrically connected to a power transmission and/or reception circuit, such as a wireless charging circuit. In some embodiments, the first contact 940-a and the second contact 940-b of the PCB 940 may be electrically connected to a communication circuit, such as a short-range communication circuit. For example, the first contact 940-a of the PCB 940 may be for feeding, and the second contact 940-b may be electrically connected to a ground member, such as a PCB ground of the external electronic device 900.

The external electronic device 900 may include a first electrical connection means 980-a for electrically connecting the first contact 940-a of the PCB 940 and the first contact 970-a of the at least one coil-shaped metal pattern 970, and a second electrical connection means 980-b for electrically connecting the second contact 940-b of the PCB 940 and the second contact 970-b of the at least one coil-shaped metal pattern 970. For example, the first electrical connection means 980-a and/or the second electrical connection means 980-b may include a C-clip, a pogo-pin, a spring, a conductive Poron and rubber, a conductive tape, or a cooper connector. According to an embodiment, the first electrical connection means 980-a or the second electrical connection means 980-b may be combined to the PCB 940 or the at least one coil-shaped metal pattern 970.

The at least one coil-shaped metal pattern 970 may be electrically connected to a power transmission and/or reception circuit (or a wireless charging circuit) mounted on the PCB 940 and may be used as an antenna for wirelessly receiving or transmitting power. For example, the at least one coil-shaped metal pattern 970 may include an antenna for wireless charging, and may be used as a wireless charging antenna of a magnetic induction scheme or a magnetic resonance scheme.

In some embodiments, The at least one coil-shaped metal pattern 970 may be electrically connected to a communication circuit mounted on the PCB 940, and may be used as an antenna for communication of various forms, such as cellular communication, short-range communication, WiFi, Bluetooth, NFC, or GNSS, or a magnetic signal, such as MST for electronic payment transmission and/or reception.

The external electronic device 900 may include an electrical shield member 960, such as a ferrite sheet, that is disposed between the battery 950 and the at least one coil-shaped metal pattern 970 and that prevents a resonance characteristic of the at least one coil-shaped metal pattern 970 from being interfered with and degraded by the battery 950.

Referring to FIGS. 8A, 8B and 9, and to FIG. 5B which details the electronic device housing construction, the electronic device 500 may be applied to the first surface 9001 of the external electronic device 900 such that the second surface 512 of the electronic device 500 faces the first surface 9001 of the external electronic device 900. The antenna 570 of the electronic device 500 may be aligned to the at least one coil-shaped metal pattern 970 of the external electronic device 900, and an electromagnetic field 8-1 flowing in the at least one coil-shaped metal pattern 970 of the external electronic device 900 may be applied to the antenna 570, and an induced current may flow in the antenna 570. By using this induced current, the power transmission and/or reception circuit of the electronic device 500 may provide power to a load of the electronic device 500.

The electronic device 500 may be applied to the first surface 9001 of the external electronic device 900 such that the first surface 511 of the electronic device 500 faces the first surface 9001 of the external electronic device 900. The antenna 570 of the electronic device 500 may be aligned to the at least one coil-shaped metal pattern 970 of the external electronic device 900, and an electromagnetic field 8-2 flowing in the at least one coil-shaped metal pattern 970 of the external electronic device 900 may be applied to the antenna 570, and an induced current may flow in the antenna 570. By using this induced current, the power transmission and/or reception circuit of the electronic device 500 may provide power to a load of the electronic device 500.

The electronic device 500 may wirelessly receive power from other external electronic devices of various forms, without being limited to the external electronic device 900 illustrated in FIGS. 8A, 8B and 9. The external electronic device may be of various forms, including coil-shaped antennas capable of wirelessly transmitting power, and may be a wireless charging pad or a wireless charger.

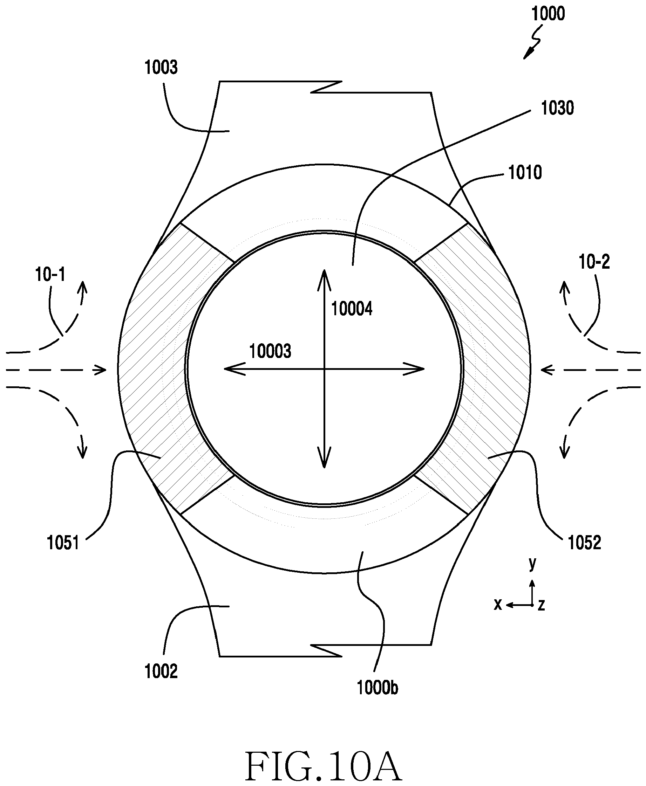

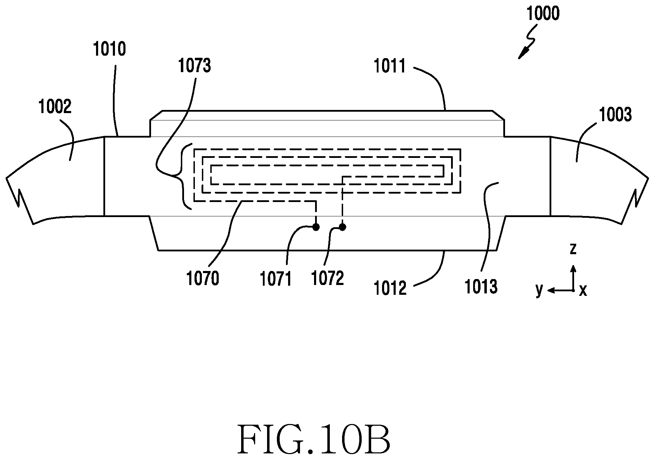

FIG. 10A illustrates an antenna installation portion in an electronic device capable of performing wireless power transmission and/or reception according to an embodiment of the present disclosure. FIG. 10B illustrates an antenna installed in the electronic device capable of performing wireless power transmission and/or reception according to an embodiment of the present disclosure.

Referring to FIGS. 10A and 10B, the electronic device 1000 may include a housing 1010, a first extension part 1002 and a second extension part 1003, which are similar to the housing 410, the first extension part 402 and the second extension part 403 of FIGS. 4B and 4C, respectively. Thus, a detailed description thereof is omitted.

The housing 1010 may include a first surface 1011 and a second surface 1012 that face in a mutually opposite direction. A display 1030 of the electronic device 1000 may be exposed through the first surface 1011. When the electronic device 1000 is worn on a user's wrist, the second surface 1012 may come in contact with the user's wrist.

The housing 1010 may include a bezel 1000b, which surrounds a space between the first surface 1011 and the second surface 1012. The first extension part 1002 and the second extension part 1003 may be connected to mutually opposite sides of the bezel 1000b, respectively.

The electronic device 1000 may include at least one antenna array region where at least one antenna 1070 is disposed and formed along the bezel 1000b. For example, referring to FIGs. 10A, 10B and 4E, the antenna 470e may be the at least one antenna 1070.

The antenna array region may include a first antenna array region 1051 and a second antenna array region 1052 that are disposed at mutually opposite sides. For example, a direction 10003 where the first antenna array region 1051 and the second antenna array region 1052 face each other may roughly cross at right angles to a direction 10004 where the first extension part 1002 and the second extension part 1003 face each other.

When viewed in a direction extending from the first surface 1011 to the second surface 1012, the first antenna array region 1051 and the second antenna array region 1052 may be disposed outside the display 1030.

At least one antenna 1070 may be disposed in at least one of the first antenna array region 1051 and the second antenna array region 1052 and may include a conductive line, which includes a wound portion 1073 having a plurality of turns extended from a first end part 1071 to a second end part 1072. The first end part 1071 and the second end part 1072 may be electrically connected to a power transmission and/or reception circuit or wireless communication circuit of the electronic device 1000.

According to an embodiment, a surface where at least one antenna 1070 is disposed may be disposed roughly along the third surface 1013. The electronic device 1000 may include input devices of various forms, which are disposed in a part of the third surface 1013, and the at least one antenna 1070 may be disposed in a portion where this input device is not installed. For example, the input devices includes the button 464 or 465, or a stem of a watch of FIG. 4A.

According to embodiments, at least a part of the antenna array regions 1051 and/or 1052 overlapped with the at least one antenna 1070 among the bezel 1000b of the housing 1010 may include non-conductive materials. If the non-conductive materials are included, at least one of an electromagnetic field 10-1 and 10-2 from an external electronic device may pass through the non-conductive materials, to reach the at least one antenna 1070. For example, the at least part of the portion overlapped with the at least one antenna 1070 among the bezel 1000b may be designed as a plastic frame.

When the at least one antenna 1070 of the electronic device 1000 and a coil-shaped metal pattern of an external electronic device are aligned to each other, an electromagnetic field 10-1 or 10-2 flowing in the at least one coil-shaped metal pattern of the external electronic device may be applied to the at least one antenna 1070, and an induced current may flow in the at least one antenna 1070 and provide power to a load of the electronic device 1000, such as by battery charging.

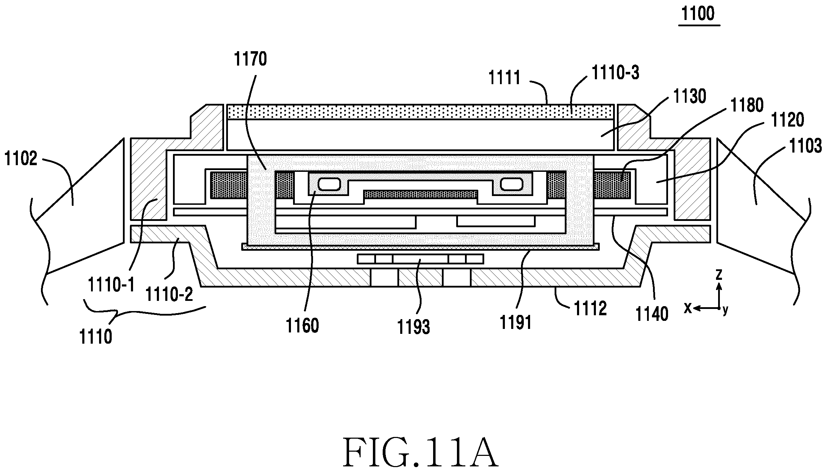

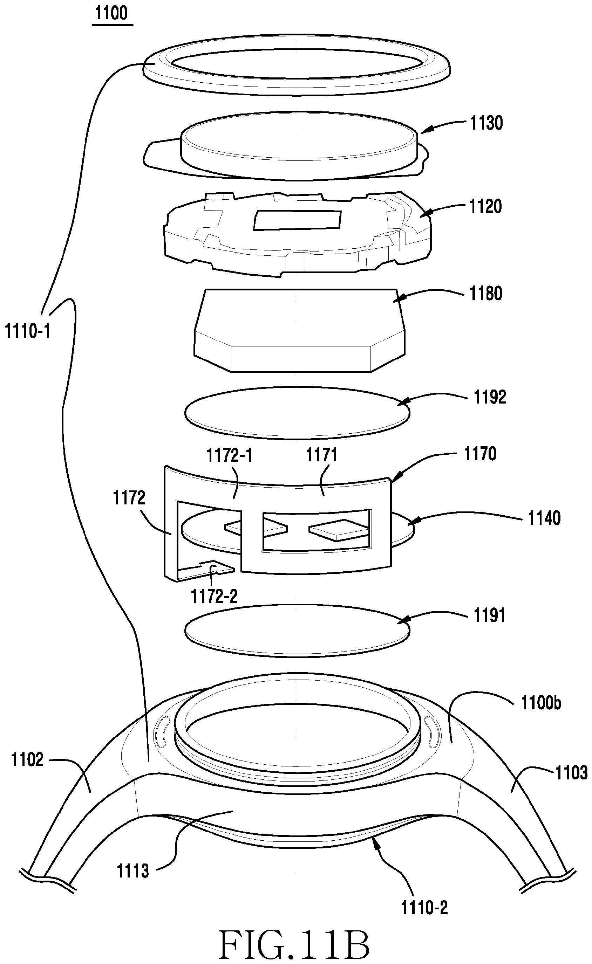

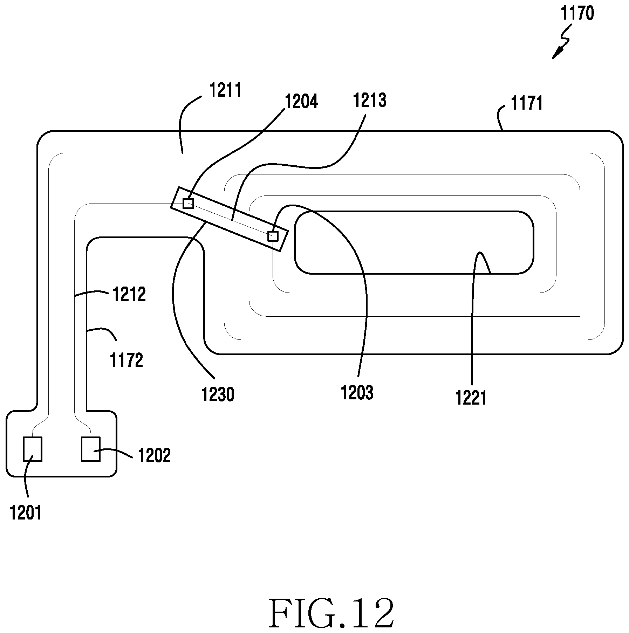

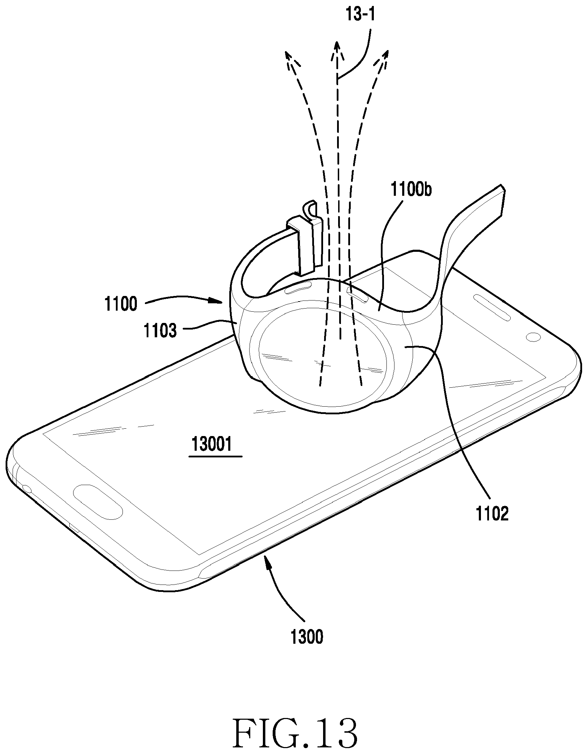

FIGS. 11A and 11B illustrate a structure of an electronic device capable of performing wireless power transmission and/or reception according to an embodiment of the present disclosure. FIG. 12 illustrates a structure of an antenna according to an embodiment of the present disclosure. FIG. 13 illustrates wireless power transmission and/or reception between an electronic device and an external electronic device according to an embodiment of the present disclosure.

Referring to FIGS. 11A and 11B, the electronic device 1100 may include a housing 1110 having a first housing 1110-1 and a second housing 1110-2, a first extension part 1102, a second extension part 1103, a window 1110-3, a bracket 1120, a display 1130, a PCB 1140, an input device 1160, electrical shield members 1191 and 1192, a battery 1180, and at least one sensor 1193, which are all similar to the elements described in the electronic device 400 of FIGS. 4B and 4C, respectively. Thus, a detailed description thereof is omitted.

The electronic device 1100 may include an antenna 1170 that is disposed in a portion surrounding a space between a first surface 1111 and a second surface 1112. According to an embodiment, a surface where the antenna 1170 is disposed may be disposed roughly along a third surface 1113 of the bezel 1100b.

The antenna 1170 may include a ring-shaped part 1171 in a rectangular or other forms, disposed to roughly cross at right angles to a direction where the first extension part 1102 and the second extension part 1103 face each other. For example, the direction where the first extension part 1102 and the second extension part 1103 face each other may be the direction 4005 of FIG. 4C.

The antenna 1170 may include an extension part 1172 that is extended from the ring-shaped part 1171. One end part 1172-1 of the extension part 1172 may be electrically connected to the ring-shaped part 1171, and the other end part 1172-2 of the extension part 1172 may be electrically connected to the PCB 1140. According to an embodiment, the other end part 1172-2 of the extension part 1172 may include a connector or a contact for electrical connection with the PCB 1140.

The antenna 1170 may include a conductive line that extends from a first end part to a second end part and includes a plurality of turns. For example, the ring-shaped part 1171 of the antenna 1170 may include a wound portion including a plurality of turns.

The antenna 1170 may include a FPCB. For example, FIG. 12 illustrates a structure of the antenna 1170 of an FPCB form according to an embodiment of the present disclosure.

Referring to FIG. 12, the antenna 1170 of the FPCB form may include a first conductive line 1211, which extends from a first contact 1201 disposed in an end part of the first extension part 1172 to a third contact 1203 around an opening 1221 of the ring-shaped part 1171. A portion disposed in the ring-shaped part 1171 among the first conductive line 1211 may form a wound portion including a plurality of turns.

The antenna 1170 may include a second conductive line 1212, which extends from a second contact 1202 disposed in an end part of the first extension part 1172 to a fourth contact 1204 around the ring-shaped part 1171.

The antenna 1170 may include electrical connection members 1230 of various forms, which include a third conductive line 1213 connecting from the third contact 1203 to the fourth contact 1204. The electrical connection member 1230 may be an FPCB, and the third contact 1203 and the fourth contact 1204 may be connected to the electrical connection member 1230 using ultrasonic fusion.

According to an embodiment, a majority of conductive lines of the antenna 1170 may be electrically connected with one another, and may be formed as a single coil-shaped conductive line, which includes a plurality of turns of a form extending from the first end part 1201 to the second end part 1202.

The PCB 1140 may include a power transmission and/or reception circuit, and may wirelessly receive or transmit power using the antenna 1170 by a magnetic induction scheme.

Referring to FIGs. 13 and 11B, the electronic device 1100 may be applied to a first surface 13001 of an external electronic device 1300 such that the third surface, such as 1113 of the electronic device 1100 faces the first surface 13001 of the external electronic device 1300. For example, the electronic device 1100 may be configured in such a manner that the first extension part 1102 and the second extension part 1103 play a support role, and a portion to which the first extension part 1102 and the second extension part 1103 are not connected among the bezel 1100b comes in contact with the first surface 13001 of the external electronic device 1300.

Referring to FIGs. 11B, 13 and 9, The external electronic device 1300 may include the external electronic device 900 of FIG. 9. The antenna 1170 of the electronic device 1100 may be aligned to at least one coil-shaped metal pattern 970 of the external electronic device 1300, and an electromagnetic field 13-1 flowing in the at least one coil-shaped metal pattern of the external electronic device 1300 may be applied to the antenna 1170, and an induced current may flow in the antenna 1170 and provide power to a load of the electronic device 1100 using the power transmission and/or reception circuit.

The power transmission and/or reception circuit of the PCB 1140 may include a power transmission and/or reception circuit of a magnetic resonance scheme. For example, the antenna 1170 and a power transmitting antenna of an external electronic device may have the same resonance frequency and, based on a resonance phenomenon therebetween, the power transmission and/or reception circuit of the PCB 1140 may receive power from or transmit power to the external electronic device.

The PCB 1140 may include a communication circuit, and may support communication of various forms that use the antenna 1170.

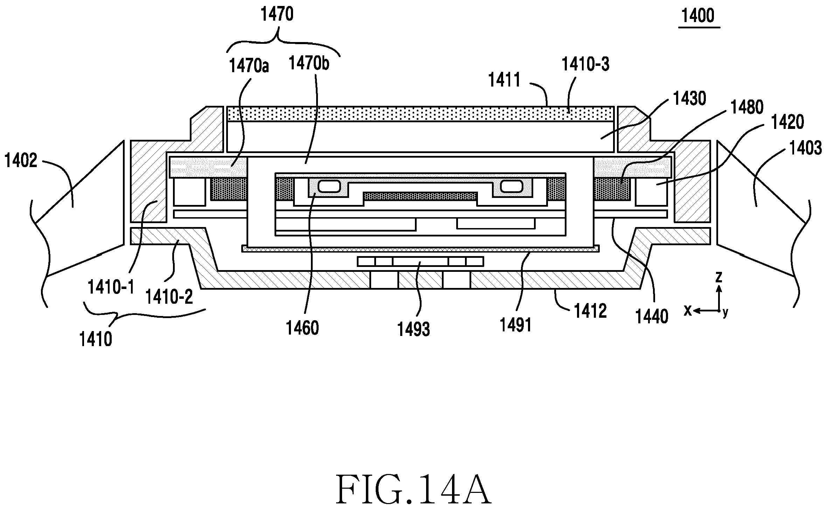

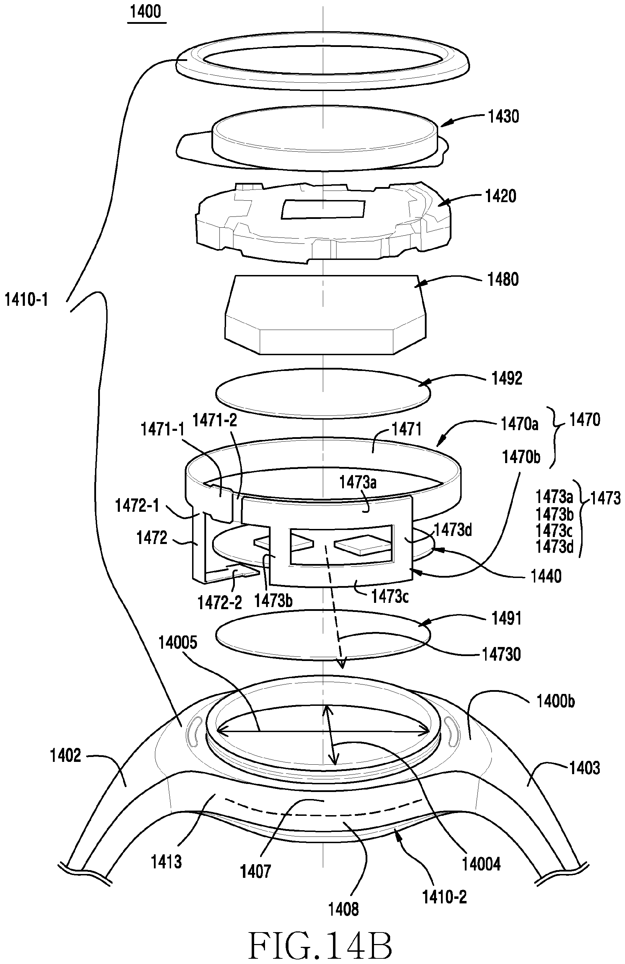

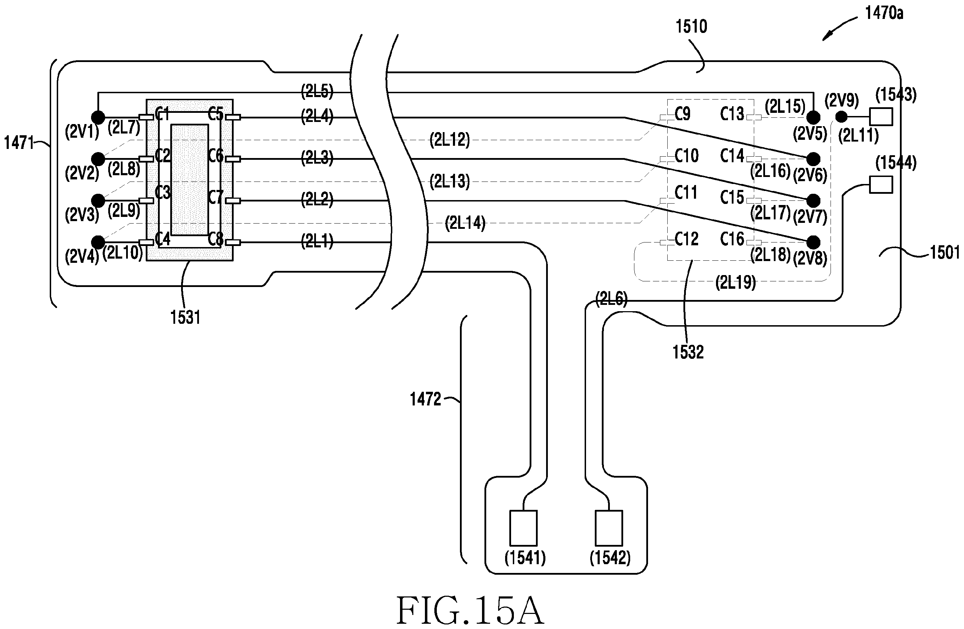

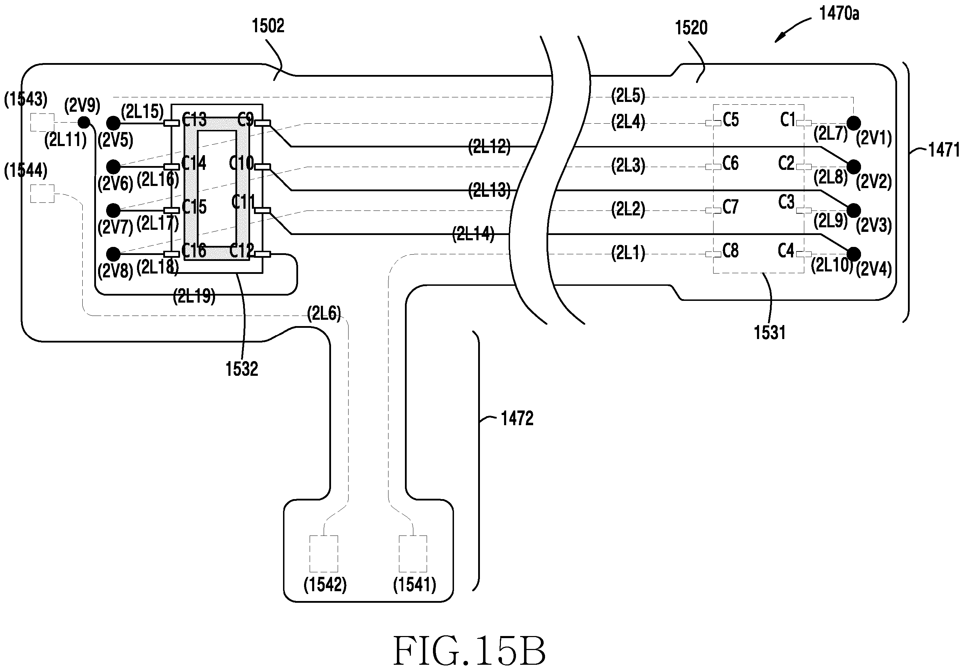

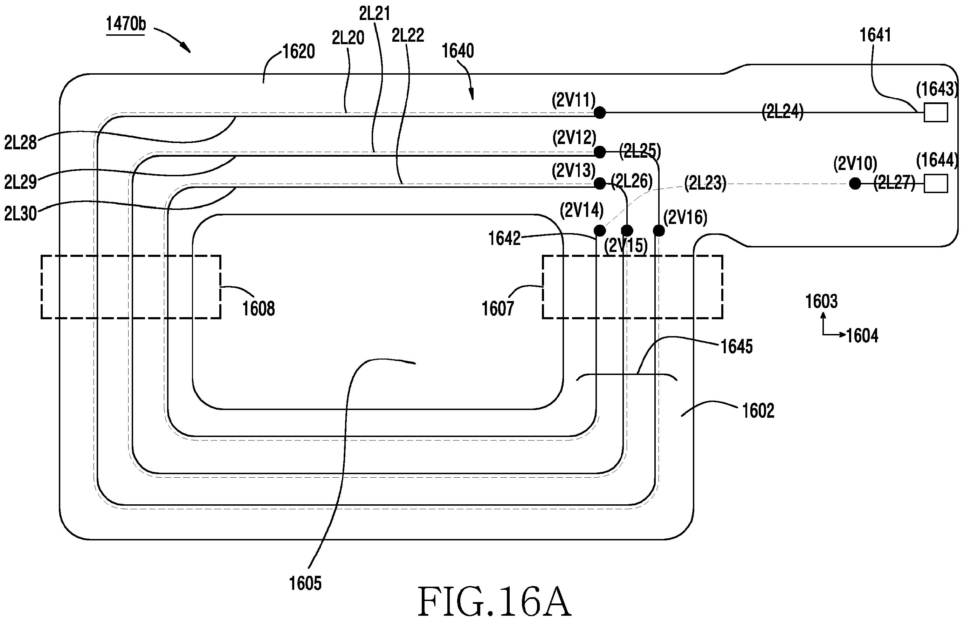

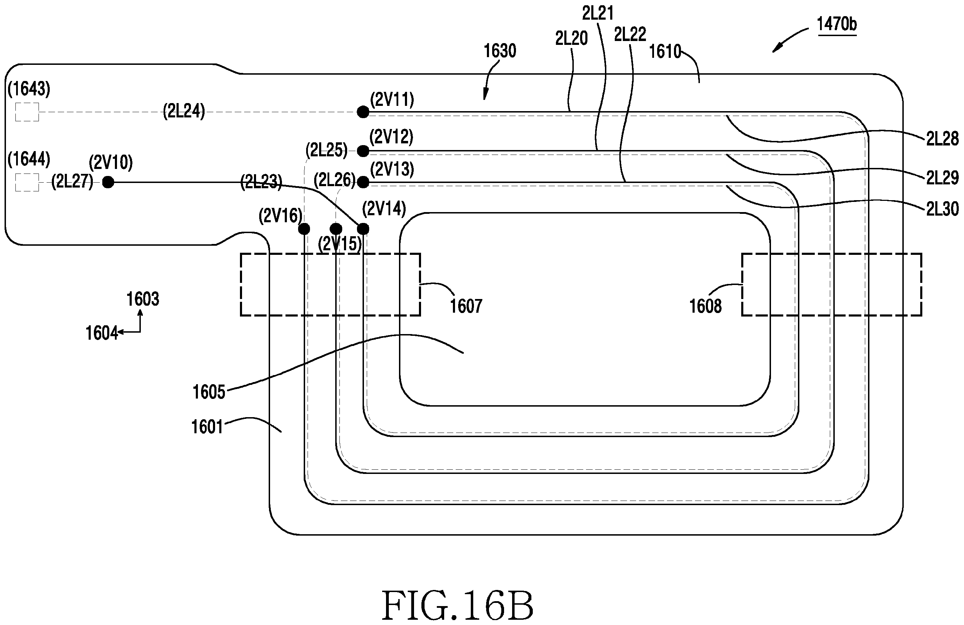

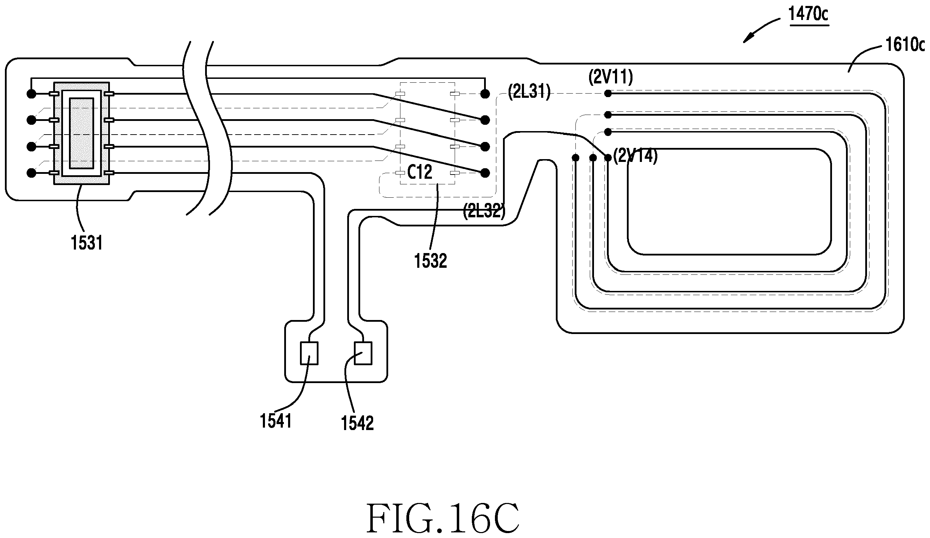

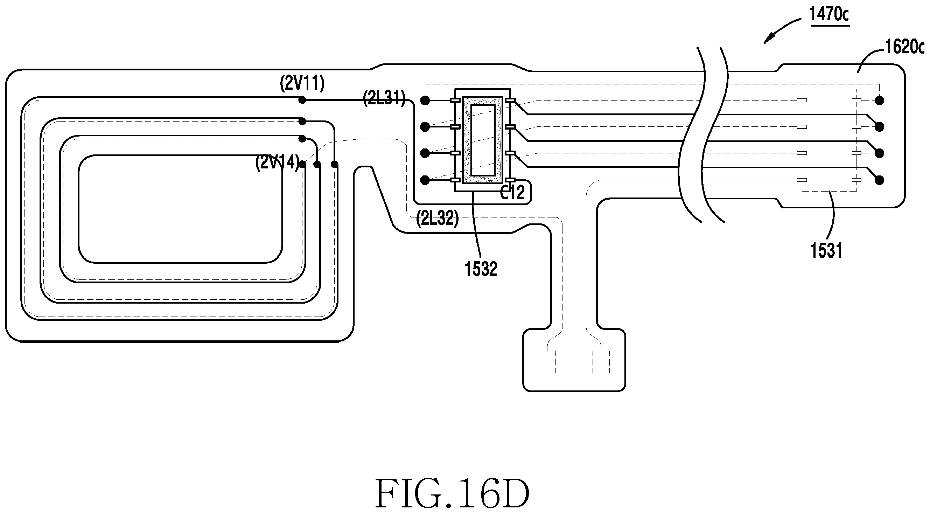

FIGS. 14A and 14B illustrate a structure of an electronic device capable of performing wireless power transmission and/or reception according to an embodiment of the present disclosure. FIGS. 15A, 15B, 16A and 16B illustrate a wiring structure of an antenna according to an embodiment of the present disclosure. FIGS. 16C and 16D illustrate a wiring structure of an antenna according to another embodiment of the present disclosure.

Referring to FIGS. 14A and 14B, the electronic device 1400 may include a housing 1410 having a first housing 1410-1 and a second housing 1410-2, a first extension part 1402, a second extension part 1403, a window 1410-3, a bracket 1420, a display 1430, a PCB 1440, an input device 1460, electrical shield members 1491 and 1492, a battery 1480, and at least one sensor 1493, and are withal similar to the elements of the electronic device 400 of FIGS. 4B and 4C, respectively. Thus, a detailed description thereof is omitted.

The electronic device 1400 may include an antenna 1470 that is disposed in a portion surrounding a space between a first surface 1411 and a second surface 1412 and includes a first antenna 1470a and a second antenna 1470b. The first antenna 1470a may include a first extension part 1471 extended from a first end part 1471-1 to a second end part 1471-2. If the first end part 1471-1 and the second end part 1471-2 are connected with each other, the first extension part 1471 may become a ring shape, and the first end part 1471-1 and the second end part 1471-2 may be electrically connected to each other. For example, the first end part 1471-1 may include a male connector, and the second end part 1471-2 may include a female connector.

The first extension part 1471 of the first antenna 1470a may be disposed along a bezel 1400b of the housing 1410. The first extension part 1471 of the first antenna 1470a may, as illustrated, surround the bracket 1420.

The first antenna 1470a may include a second extension part 1472 that is extended from the first extension part 1471. One end part 1472-1 of the second extension part 1472 may be electrically connected to the first extension part 1471, and the other end part 1472-2 of the second extension part 1472 may be electrically connected to the PCB 1440 by a connector or a contact.

The first antenna 1470a may be a form similar to the antenna 570 of FIG. 5B.

The second antenna 1470b may be disposed on a surface that roughly contours to a third surface 1413 of the bezel 1400b, and may include a ring-shaped part 1473. The bezel 1400b may include dual side portions corresponding to a direction 14004 that crosses at right angles to a direction 14005 between the first extension part 1402 and the second extension part 1403, and the ring-shaped part 1473 of the second antenna 1470b may be disposed in or adjacent to at least one of these dual side portions. The ring-shaped part 1473 may be of a shape that is roughly curved centering on an axis 14730 that may be in parallel with the direction 14004.

According to one embodiment, the second antenna 1470b may include an extension part 1472 that is extended from the ring-shaped part 1473. An end part 1474-2 of the extension part 1172 may be electrically connected to the first antenna 1470a. The end part 1474-2 of the extension part 1172 may include a connector, a contact, etc. for electrical connection with the first antenna 1470a.

The ring-shaped part 1473 of the second antenna 1470b may be roughly a rectangular ring form that includes a first length part 1473a, a second length part 1473b, a third length part 1473c and a fourth length part 1473d. The first length part 1473a may be disposed to overlap with the first extension part 1471 of the first antenna 1470a, such as by being disposed between the first extension part 1471 of the first antenna 1470a and the bezel 1400b, and may be combined to the first extension part 1471 of the first antenna 1470a by a combination means such as a bond.

According to an embodiment, at least one portion overlapped with the second antenna 1470b among the bezel 1400b may include non-conductive materials, and an electromagnetic field from an external electronic device may pass through the non-conductive materials of the third surface 1413, to reach the second antenna 1470b. A region 1408 overlapped with the second length part 1473b, third length part 1473c and fourth length part 1474d of the second antenna 1470b among the bezel 1400b may be molded with non-conductive materials. A region 1407 overlapped with the first extension part 1471 of the first antenna 1470a or the first length part 1473a of the second antenna 1470b among the bezel 1400b may be molded with conductive materials.

The antenna 1470 may include a conductive line that extends from a first end part to a second end part and includes a plurality of turns, may be molded in a flexible film form as a flexible film antenna, and may include a multi-layer.

FIGS. 15A and 15B illustrate a wiring structure of the first antenna 1470a, and FIGS. 16A and 16B illustrate a wiring structure of the second antenna 1470b, according to embodiments of the present disclosure.

When the first antenna 1470a and the second antenna 1470b are electrically connected to each other, one coil-shaped conductive line including a plurality of turns of a form extended from a first end part to a second end part may be formed and may generate a magnetic field in the first direction 4001 or second direction 4002 of an electronic device400, as in FIG. 4B, or a magnetic field in the direction 4003 that crosses at right angles to the first direction 4001.

Referring to FIGS. 15A and 15B, the first antenna 1470a may include a first layer 1510 and a second layer 1520, a first connector, such as a socket connector 1531 that is disposed on a surface 1501 of the first layer 1510, and a second connector, such as a header connector 1532, that is disposed on a surface 1502 of the second layer 1520. The first connector 1531 may be disposed at one end part of the first antenna 1470a, and the second connector 1532 may be disposed at the other end part of the first antenna 1470a. If the first connector 1531 and the second connector 1532 are connected with each other, the first antenna 1470a may be deformed into a ring form.

The first antenna 1470a may include a first via set (or group) including a first via (2V1), a second via (2V2), a third via (2V3) and a fourth via (2V4), formed at one end part of the first extension part 1471, and a second via set including a fifth via (2V5), a sixth via (2V6), a seventh via (2V7), an eighth via (2V8) and a ninth via (2V9), formed at the other end part of the first extension part 1471. When viewed in an unfolded state of the first antenna 1470a, the first connector 1531 and the second connector 1532 may be disposed between the first via set and the second via set.

The first connector 1531 may be similar to the first connector 731 illustrated in FIG. 7C, and include a plurality of contacts (C1, C2, C3, C4, C5, C6, C7, and C8). The first layer 1510 may include an input contact 1541 and an output contact 1542, which are disposed on the surface 1501 of an end part side of the second extension part 1472, and may include a first connection contact 1543 and a second connection contact 1544, which are disposed on the surface 1501 of an end part side of the first extension part 1471. When viewed in an unfolded state of the first antenna 1470a, the second connector 1532 and the second via set (2V5, 2V6, 2V7, 2V8, and 2V9) may be disposed between the first connector 1531 and the connection contacts 1543 and 1544.

The first layer 1510 may include a first conductive line (2L1) connecting the input contact 1541 and the eighth contact (C8), a second conductive line (2L2) connecting the seventh contact (C7) and the eighth via (2V8), a third conductive line (2L3) connecting the sixth contact (C6) and the seventh via (2V7), a fourth conductive line (2L4) connecting the fifth contact (C5) and the sixth via (2V6), a fifth conductive line (2L5) connecting the first via (2V1) and the fifth via (2V5), a sixth conductive line (2L6) connecting the output contact 1542 and the second connection contact 1544, and conductive lines (2L7, 2L8, 2L9, and 2L10) connecting the first via set (2V1, 2V2, 2V3, and 2V4) and one-side contacts (C1, C2, C3, and C4). The first layer 1510 may include an eleventh conductive line (2L11) connecting the ninth via (2V9) and the first connection contact 1543.

The second connector 1532 may be similar to the second connector 732 illustrated in FIG. 7D, and include a plurality of contacts (C9, C10, C11, C12, C13, C14, C15, and C16). The second layer 1520 may include a twelfth conductive line (2L12) connecting the second via (2V2) and the ninth contact (C9), a thirteenth conductive line (2L13) connecting the third via (2V3) and the tenth contact (C10), a fourteenth conductive line (2L14) connecting the fourth via (2V4) and the eleventh contact (2C11), a fifteenth conductive line (2L15) connecting the thirteenth contact (C13) and the fifth via (2V5), a sixteenth conductive line (2L16) connecting the fourteenth contact (C14) and the sixth via (2V6), a seventeenth conductive line (2L17) connecting the fifteenth contact (C15) and the seventh via (2V7), an eighteenth conductive line (2L18) connecting the sixteenth contact (C16) and the eighth via (2V8), and a nineteenth conductive line (2L19) connecting the twelfth contact (C12) and the ninth via (2V9).

According to an embodiment, if the first connector 1531 and the second connector 1532 are connected with each other, a majority of conductive lines of the first antenna 1470a are electrically connected to one another, thereby forming a coil-shaped conductive line including a plurality of turns of a form extended from the input contact 1541 to the third connection contact 1543.

For example, if the first connector 1531 and the second connector 1532 are connected with each other, the contacts (C1, C2, C3, C4, C5, C6, C7, and C8) of the first connector 1531 may be electrically connected to the contacts (C9, C10, C11, C12, C13, C14, C15, and C16) of the second connector 1532, respectively, and electrical connection may be made between the first conductive line (2L1) and the second conductive line (2L2), the second conductive line (2L2) and the third conductive line (2L3), the third conductive line (2L3) and the fourth conductive line (2L4), the fourth conductive line (2L4) and the fifth conductive line (2L5), the fifth conductive line (2L5) and the twelfth conductive line (2L12), the twelfth conductive line (2L12) and the thirteenth conductive line (2L13), the thirteenth conductive line (2L13) and the fourteenth conductive line (2L14), and the fourteenth conductive line (2L14) and the nineteenth conductive line (2L19), in accordance with a connection scheme previously described in FIGS. 7C and 7D.

Referring to FIGS. 16A and 16B, the second antenna 1470b may include a first layer 1610 and a second layer 1620. When the first antenna 1470a and the second antenna 1470b are connected with each other, the second layer 1620 may be disposed to face the first antenna 1470a.

Referring to FIG. 16A, the second layer 1620 of the second antenna 1470b may include a third connection contact 1643 and a fourth connection contact 1644 that are disposed on a surface 1602. When the first antenna 1470a and the second antenna 1470b are connected with each other, the first connection contact 1543 and second connection contact 1544 of the first antenna 1470a may be electrically connected to the third connection contact 1643 and fourth connection contact 1644 of the second antenna 1470b, respectively. One or more coil-shaped conductive lines including a plurality of turns as in FIG. 10B may be included between the third connection contact 1643 and fourth connection contact 1644 of the second antenna 1470b.

The second layer 1620 of the second antenna 1470b may include a second layer conductive line 1640 which is extended from one end part 1641 to the other end part 1642 to have a plurality of turns. The one end part 1641 of the second layer conductive line 1640 may be electrically connected to the third connection contact 1643.

The second layer conductive line 1640 may include a thirtieth conductive line (2L30) forming the innermost turn. The second antenna 1470b may include a fourteenth via (2V14) formed in one end part 1642 of the thirtieth conductive line (2L30), and a thirteenth via (2V13) formed in the other end part of the thirtieth conductive line (2L30). The second layer conductive line 1640 may include a twenty-sixth conductive line (2L26) and a twenty-ninth conductive line (2L29) that form the second turn. One end part of the twenty-sixth conductive line (2L26) may be electrically connected to the thirteenth via (2V13), and the other end part of the twenty-sixth conductive line (2L26) may be electrically connected to a fifteenth via (2V15) formed between the twenty-sixth conductive line (2L26) and the twenty-ninth conductive line (2L29). One end part of the twenty-ninth conductive line (2L29) may be electrically connected to the fifteenth via (2V15), and the other end part of the twenty-ninth conductive line (2L29) may be electrically connected to a twelfth via (2V12) formed in a position originating the third turn. The second layer conductive line 1640 may include a twenty-fifth conductive line (2L25) forming the third turn and a twenty-eighth conductive line (2L28). One end part of the twenty-fifth conductive line (2L25) may be electrically connected to the twelfth via (2V12), and the other end part of the twenty-fifth conductive line (2L25) may be electrically connected to a sixteenth via (2V16) formed between the twenty-fifth conductive line (2L25) and the twenty-eighth conductive line (2L28). One end part of the twenty-eighth conductive line (2L28) may be electrically connected to the sixteenth via (2V16), and the other end part of the twenty-eighth conductive line (2L28) may be electrically connected to a eleventh via (2V11) formed between the twenty-eighth conductive line (2L28) and a twenty-fourth conductive line (2L24). The second layer conductive line 1640 may include the twenty-fourth conductive line (2L24) connecting between the eleventh via (2V11) and the third connection contact 1643.

The second antenna 1470b may include a tenth via (2V10) which is formed near the fourth connection contact 1644. The second layer 1620 may include a twenty-seventh conductive line (2L27) electrically connecting the tenth via (2V10) and the fourth connection contact 1644.

The fourteenth via (2V14), the thirteenth via (2V13), the twelfth via (2V12) and the eleventh via (2V11) may be straight arranged in a first direction 1603, and the fourteenth via (2V14), the fifteenth via (2V15) and the sixteenth via (2V16) may be straight arranged in a second direction 1604 crossing at a right angle to the first direction 1603.

The tenth via (2V10) may be disposed outside a wound portion 1645 or between the wound portion 1645 and the fourth connection contact 1644.

The second antenna 1470b may be roughly a rectangular ring form including an opening 1605, but also may be various ring forms such as a round ring. The opening 1605 may be omitted.

Referring to FIG. 16B, the first layer 1610 of the second antenna 1470b may include a first layer conductive line 1630 that is disposed around the opening 1605 and includes a twentieth conductive line (2L20) connecting a eleventh via (2V11) and a sixteenth via (2V16), a twenty-first conductive line (2L21) connecting a twelfth via (2V12) and a fifteenth via (2V15), a twenty-second conductive line (2L22) connecting a thirteenth via (2V13) and a fourteenth via (2V14), and a twenty-third conductive line (2L23) connecting the fourteenth via (2V14) and a tenth via (2V10). The twenty-first conductive line (2L21) may be disposed outside the twenty-second conductive line (2L22), and the twentieth conductive line (2L20) may be disposed outside the twenty-first conductive line (2L21).

When the first connector 1531 and second connector 1532 of the first antenna 1470a are connected with each other, and the first connection contact 1543 and second connection contact 1544 of the first antenna 1470a are connected to the third connection contact 1643 and fourth connection contact 1644 of the second antenna 1470b, one coil-shaped conductive line including a plurality of turns of a form extended from the input contact 1541 to the output contact 1542 may be formed and used as a wireless power transmitting and/or receiving antenna for wirelessly receiving power from, or transmitting power to, the external electronic device. Referring back to FIGS. 4B and 10B, in the coil-shaped conductive line, the first antenna 1470a may provide a first conductive line wound in a coil form centering on an axis of a first direction 4001, and for generating a magnetic field in the first direction 4001 or a second direction 4002, and the second antenna 1470b may provide a second conductive line 1070 wound in a coil form centering on an axis of a direction 4003 crossing at right angles to the first direction 4001, and for generating a magnetic field in the direction crossing at right angles to the first direction 4001.

According to embodiments, at least one portion 1607 and/or 1608 of the second antenna 1470b may be designed to have a relatively higher flexibility than the periphery outside the at least one portion 1607 and 1608. According to an embodiment, the at least one portion 1607 and 1608 may be designed to have more thinner thickness that the periphery outside the at least one portion 1607 and 1608. For example, the connection region 1607 between the first length part 1473a and second length part 1473b of the ring-shaped part 1473 of FIG. 14B, or the connection region 1608 between the first length part 1473a and the fourth length part 1473d may be designed to have high flexibility. Referring to FIG. 14B, when the second antenna 1470b is disposed along an inner side of the housing 1410-1, the second antenna 1470b may be easily deformed along the inner side of the housing 1410-1 by the at least one portion 1607 and/or 1608.

A form of the first antenna 1470a and/or second antenna 1470b and elements thereof in FIGS. 15A to 16B may vary. For example, the contacts and the conductive lines may be changed in number and position, resulting in the possibility of a coil-shaped conductive line including a plurality of turns of various forms.

The first antenna 1470a and/or the second antenna 1470b may be molded in various forms and with one FPCB. FIGS. 16C and 16D illustrate a wiring structure of an antenna according to another embodiment of the present disclosure. The first antenna 1470a of FIGS. 15A and 15B and the second antenna 1470b of FIGS. 16A and 16B may be molded as one antenna 1470c of FIGS. 16C and 16D, and the one antenna 1470c may be replaced with the antenna 1470 of FIGS. 14A and 14B.

For example, the antenna 1470c may include a first layer 1610c and a second layer 1620c. In place of the nineteenth conductive line (2L19), ninth via (2V9) and first connection contact 1543 of the first antenna 1470a illustrated in FIGS. 15A and 15B, and the third connection contact 1643 and twenty-fourth conductive line (2L24) of the second antenna 1470b illustrated in FIGS. 16A and 16B, a thirty-first conductive line (2L31) electrically connecting between the twelfth contact (C12) and the eleventh via (2V11) may be formed in the second layer 1620c. In place of the sixth conductive line (2L6) and second connection contact 1544 of the first antenna 1470a illustrated in FIGS. 15A and 15B, and the fourth connection contact 1644, twenty-seventh conductive line (2L27), tenth via (2V10) and twenty-third conductive line (2L23) of the second antenna 1470b illustrated in FIGS. 16A and 16B, a thirty-second conductive line (2L32) electrically connecting between the output contact 1542 and the fourteenth via (2V14) may be formed in the first layer 1610c.

If the first connector 1531 and second connector 1532 of the antenna 1470c of FIGS. 16C and 16D are connected with each other, one coil-shaped conductive line including a plurality of turns of a form extended from the input contact 1541 to the output contact 1542 may be formed and used as a wireless power transmitting and/or receiving antenna for wirelessly receiving power from, or transmitting power to, the external electronic device. Referring back to FIGS. 4B, 6 and 10B, the one coil-shaped conductive line may include a first conductive line570 wound in a coil form centering on an axis of a first direction 4001, and for generating a magnetic field in the first direction 4001 or a second direction 4002, and a second conductive line 1070 wound in a coil form centering on an axis of a direction 4003 crossing at right angles to the first direction 4001, and for generating a magnetic field in the direction crossing at right angles to the first direction 4001.

The PCB 1440 may include a power transmission and/or reception circuit, and may wirelessly receive or transmit power using the antenna 1470 in a magnetic induction scheme. For example, when the electronic device 1400 is disposed on the first surface 9001 of the external electronic device 900 as in FIG. 8A or FIG. 8B, the first antenna 1470a of the electronic device 500 may be aligned to at least one coil-shaped metal pattern 970 of the external electronic device 900, an electromagnetic field flowing in the at least one coil-shaped metal pattern 970 of the external electronic device 900 may be applied to the first antenna 1470a, and an induced current may flow in the first antenna 1470a. By using this induced current, the power transmission and/or reception circuit of the electronic device 500 may provide power to a load of the electronic device 1400.
When the electronic device 1100 is disposed on the first surface 13001 of the external electronic device 1300 as in FIG. 13, the second antenna 1470b of the electronic device 1100 may be aligned to at least one coil-shaped metal pattern 970 of the external electronic device 1300, and an electromagnetic field flowing in the at least one coil-shaped metal pattern 970 of the external electronic device 1300 may be applied to the second antenna 1470b, and an induced current may flow in the second antenna 1470b and by used by the power transmission and/or reception circuit of the electronic device 1100 to provide power to a load of the electronic device 1100.

The power transmission and/or reception circuit of the PCB 1440 may include a power transmission and/or reception circuit of a magnetic resonance scheme. For example, at least one of the first antenna 1470a and the second antenna 1470b and a power transmitting antenna of the external electronic device may have the same resonance frequency and, by using a resonance phenomenon therebetween, the power transmission and/or reception circuit may receive power from, or transmit power to, the external electronic device.

The PCB 1440 may include a communication circuit, and may support communication of various forms that use at least one of the first antenna 1470a and the second antenna 1470b.

An electronic device may include a housing including a first surface facing in a first direction, and a second surface facing in a second direction that is opposite to the first direction, a display disposed between the first surface and the second surface, and exposed through the first surface, and a conductive line extended from a first end part to a second end part to include a plurality of turns that surround a space between the first surface and the second surface, and generating a magnetic field in the first direction or second direction or a magnetic field in a direction crossing at right angles to the first direction.

The conductive line may include a first conductive line surrounding the space, and wound in a coil form centering on an axis of the first direction, and generating the magnetic field in the first direction or second direction.

The conductive line may include a second conductive line disposed in at least a part of a portion surrounding the space, and wound in a coil form centering on an axis of the direction crossing at right angles to the first direction, and generating a magnetic field in the direction crossing at right angles to the first direction.

The electronic device may further include a bezel surrounding the space, and a pair of extension parts combined to both sides of the bezel, and used for wearing on the wrist, wherein the second conductive line may be disposed in a direction crossing at right angles to a direction between the pair of extension parts.

The electronic device may include at least one conductive plate surrounded by the plurality of turns of the conductive line, and disposed to be roughly in parallel with the first surface or second surface.

The plurality of turns of the conductive line are disposed in a circular ring form along the space between the first surface and second surface, and the at least one conductive plate is a circular plate of a size available to be disposed inside the circular ring form.

The electronic device may further include a flexible film in which the conductive line is disposed.

The electronic device may further include a circuit electrically connected to the first end part and second end part of the conductive line, and wirelessly receiving or transmitting power through the conductive line.

The circuit may include at least one circuit among a wireless power transmission and/or reception circuit of a magnetic induction scheme and a wireless power transmission and/or reception circuit of a magnetic resonance scheme.

An electronic device may include a housing including a first surface facing in a first direction, and a second surface facing in a second direction that is opposite to the first direction, a display disposed between the first surface and the second surface, and exposed through the first surface, and a flexible film of a ring form including a plurality of conductive lines, and surrounding a space between the first surface and second surface, wherein the conductive lines may be electrically connected to one another, to form one conductive line of a form that is extended from a first end part to a second end part to include a plurality of turns, and the one conductive line may generate a magnetic field in the first direction or second direction or a magnetic field in a direction crossing at right angles to the first direction.

The one conductive line may include a first conductive line surrounding the space, and wound in a coil form centering on an axis of the first direction, and generating a magnetic field in the first direction or second direction, and a second conductive line disposed in at least a part of a portion surrounding the space, and wound in a coil form centering on an axis of a direction crossing at right angles to the first direction, and generating a magnetic field in the direction crossing at right angles to the first direction.

The housing may include a bezel surrounding the space, and at least one portion of the bezel overlapping with the second conductive line may include non-conductive materials.

The flexible film may include a first flexible film and a second flexible film which are separable from each other, and the first flexible film may include the first conductive line, and the second flexible film may include the second conductive line.

The flexible film may include a first connector and a second connector which are electrically connected to the majority of conductive lines and are disposed at both ends of the flexible film respectively, and if the first connector and the second connector are connected to each other, the flexible film may be deformed into a ring form surrounding the space between the first surface and the second surface, and the one conductive line may be formed.

The flexible film may include a multi-layer on which the majority of conductive lines have been disposed, and at least one via formed in the multi-layer, wherein the at least one conductive line may be formed by the electrical connection between the first connector and second connector and the at least one via.

The electronic device may further include at least one conductive plate surrounded by the flexible film, and disposed to be roughly in parallel with the first surface or second surface.

The electronic device may further include a PCB that includes a circuit surrounded by the flexible film, and is electrically connected to the first end part and second end of the one conductive line and wirelessly receives or transmitting power using the one conductive line, and may include a watch that is wearable on a user's wrist.

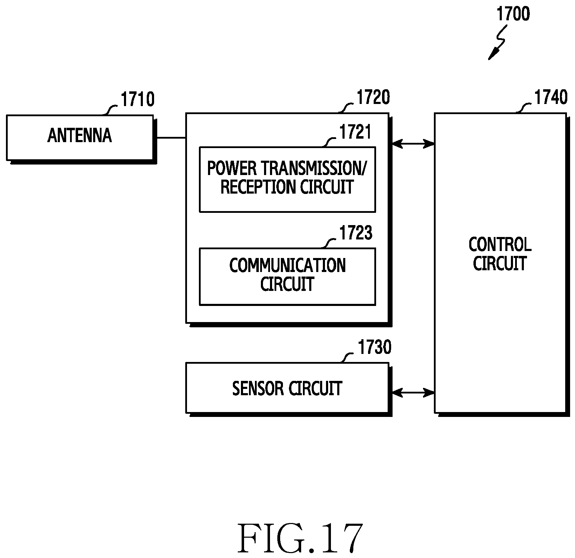

FIG. 17 illustrates an electronic device capable of transmitting and/or receiving wireless power according to an embodiment of the present disclosure. The electronic device 1700 may include one of the electronic device 400 of FIGS. 4A to 4C, the electronic device 500 of FIGS. 5A and 5B, the electronic device 1100 of FIGS. 11A and 11B, or the electronic device 1400 of FIGS. 14A and 14B.

Referring to FIG. 17, the electronic device 1700 may include at least one antenna 1710, an electromagnetic field circuit 1720, a sensor circuit 1730, and a control circuit 1740.

The at least one antenna 1710 may be metal members of various forms that are installed in the electronic device 1700, may be disposed within a housing forming an appearance of the electronic device 1700, or may form a part of one surface of the housing. The at least one antenna 1710 may be the form of at least one of a metal plate, a coil-shaped metal pattern or a ring-shaped metal member. The at least one antenna 1710 may include at least one of the antenna 570 of FIGS. 5A and 5B, the antenna 570 of FIGS. 7A and 7B, the antenna 1070 of FIG. 10B, the antenna 1170 of FIGS. 11A and 11B, the antenna 1170 of FIG. 12, the antenna 1470 of FIGS. 14A and 14B, the first antenna 1470a of FIGS. 15A and 15B, or the second antenna 1470b of FIGS. 16A and 16B..

The at least one antenna 1710 may include a radiator, such as a coil, for supporting a power transmission and/or reception circuit 1721. For example, the power transmission and/or reception circuit 1721 may wirelessly receive power from, or wirelessly transmit power to, the external electronic device, using the at least one antenna 1710.

The at least one antenna 1710 may include a radiator for supporting short-range communication of various forms of a communication circuit 1723 or magnetic signal transmission and/or reception.

According to embodiments, at least a part of the at least one antenna 1710 may be used for cellular communication, such as by LTE, LTE-A, CDMA, WCDMA, UMTS, WiBro, or GSM.

The electromagnetic field circuit 1720 may be electrically connected to the at least one antenna 1710, may wirelessly transmit and/or receive a signal or wirelessly receive or transmit power, using at least a part of the at least one antenna 1710, and may include the power transmission and/or reception circuit 1721 and the communication circuit 1723.

The power transmission and/or reception circuit 1721 may wirelessly receive or transmit power using at least a part of the at least one antenna 1710, and may be a power transmission and/or reception circuit of a magnetic induction scheme. For example, if a magnetic field flowing in an antenna of an external electronic device is applied to the at least one antenna 1710, an induced current gets to flow in at least a part of the at least one antenna 1710 and, by using this induced current, the power transmission and/or reception circuit 1721 may provide power to a load of the electronic device 1700. The power transmission and/or reception circuit 1721 may wirelessly transmit power to the external electronic device using magnetic induction between the antenna of the external electronic device and the at least part of the at least one antenna 1710 of the electronic device 1700.

The power transmission and/or reception circuit 1721 of the magnetic induction scheme may comply with the wireless power consortium (WPC) standard, and thus may wirelessly receive power from an external electronic device or wirelessly transmit power to the external electronic device, using a frequency of 110 to 205 kilo hertz (KHz). The power transmission and/or reception circuit 1721 of the magnetic induction scheme may comply with the power matters alliance (PMA) standard, and thus may wirelessly receive power from the external electronic device or wirelessly transmit power to the external electronic device, using a frequency of 227 to 357 KHz or 118 to 153 KHz.

According to another embodiment, the power transmission and/or reception circuit 1721 may be a power transmission and/or reception circuit of a magnetic resonance scheme. For example, at least a part of the at least one antenna 1710 and a power transmitting antenna of the external electronic device may have the same resonance frequency and, by using a resonance phenomenon therebetween, the power transmission and/or reception circuit 1721 may receive power from the external electronic device or transmit power to the external electronic device.

The power transmission and/or reception circuit 1721 of the magnetic resonance scheme may comply with the alliance for wireless power (A4WP) standard, and thus may wirelessly receive power from the external electronic device or wirelessly transmit power to the external electronic device, using a resonance frequency of 6.78 megahertz (MHz).

The communication circuit 1723 may support communication of various forms that use at least a part of the at least one antenna 1710 and may include a short-range communication circuit, and may support short-range communication with the external electronic device using a part of the at least one antenna 1710. The short-range communication may include MST for electronic payment with the external electronic device, which is a communication technology for off-line payment using a magnetic field, and may be used for performing communication with a POS device.

The communication circuit 1723 may perform short-range communication of various forms using the at least one antenna 1710. For example, when using the MST, the communication circuit 1723 may wirelessly transmit a signal to the POS device using a frequency of 70 KHz.

The communication circuit 1723 may include a cellular communication circuit, and may transmit a mobile communication signal to a base station or receive from the base station, using at least a part of the at least one antenna 1710.

The electromagnetic field circuit 1720 may include an inverter and rectifier. For example, the electromagnetic field circuit 1720 may use the inverter when driving a communication system, and may use the rectifier when driving a wireless power transmission and/or reception system.

The communication circuit 1723 of the electromagnetic field circuit 1720 may be a single component form, such as an SoC. The power transmission and/or reception circuit 1721 of the electromagnetic field circuit 1720 may be an SoC.

The sensor circuit 1730 may detect various state information of the electronic device 1700 and an external electronic device.

The electromagnetic field circuit 1720 may be a single component form, such as an SOC, including all of the power transmission and/or reception circuit 1721 and the communication circuit 1723.

The control circuit 1740 may be electrically connected to the electromagnetic field circuit 1720 and may execute various instructions based on at least a part of at least one input. The various instructions may be stored in a memory of the control circuit 1740. For example, the control circuit 1740 may selectively activate the power transmission and/or reception circuit 1721 of the electromagnetic field circuit 1720 based on the at least part of the at least one input. The control circuit 1740 may selectively activate the communication circuit 1723 of the electromagnetic field circuit 1720 based on the at least part of the at least one input. The at least one input may include a signal that is inputted through an input device of the electronic device 1700. The at least one input may include a signal that is sensed through a sensor module of the electronic device 1700. The at least one input may include a signal that is wirelessly or wiredly received from an external electronic device.

When receiving a request for a light receiving mode from an external electronic device through the communication circuit 1723, the control circuit 1740 may enter the light receiving mode and activate at least one light detector of the sensor circuit 1730. When an optical signal of a corresponding wavelength band generated from the external electronic device is detected through at least one light detector, the control circuit 1740 may transmit a response to the optical signal detection to the external electronic device through the communication circuit 1723, may receive a request for a wireless power reception mode from the external electronic device through the communication circuit 1723 in response to the light signal detection, and may enter the wireless power reception mode, in which the control circuit 1723 may selectively activate at least a part of the power transmission and/or reception circuit 1721.

The control circuit 1740 may receive a request a wireless power reception mode of a magnetic resonance scheme from the external electronic device through the communication circuit 1723, and enter the wireless power reception mode of the magnetic resonance scheme, in which the control circuit 1740 may selectively activate at least a part of the power transmission and/or reception circuit 1721.

In the wireless power reception mode, the control circuit 1740 may acquire information about a charging state, such as a charging time or a battery level, and transmit this information to the external electronic device through the communication circuit 1723.

According to embodiments, if an input for use of a short-range communication function is sensed, the control circuit 1740 may activate at least a part of the communication circuit 1723 of the electromagnetic field circuit 1720, in a short-range communication mode entry. If an input for non-use of the short-range communication function is sensed through an input device of the electronic device 1700, the control circuit 1740 may deactivate at least a part of the communication circuit 1723 of the electromagnetic field circuit 1720, in a short-range communication mode release.

According to embodiments, if an input for use of a short-range communication function is sensed, the control circuit 1740 may activate at least a part of the communication circuit 1723, and deactivate at least a part of the power transmission and/or reception circuit 1721 of the electromagnetic field circuit 1720.

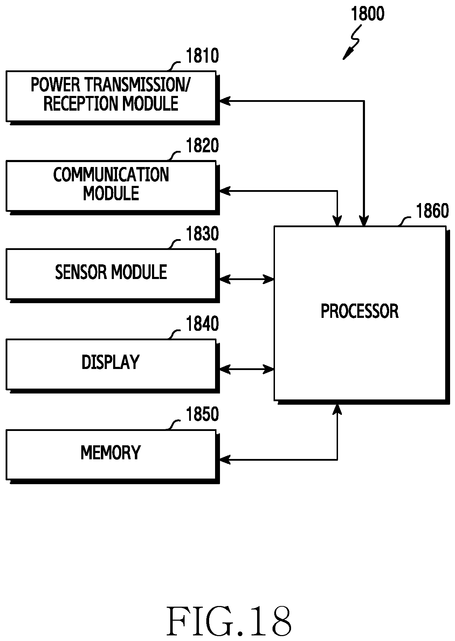

FIG. 18 illustrates an electronic device capable of providing wireless power according to an embodiment of the present disclosure. The electronic device 1800 may be the external electronic device 900 of FIGS. 8A and 8B the electronic device 1300 of FIG. 13, or the external electronic device 102 or 104 of FIG. 1.

The electronic device 1800 may include a wireless power transmission and/reception module 1810, a communication module 1820, a sensor module 1830, a display 1840, a memory 1850 and a processor 1860.

The wireless power transmission and/or reception module 1810 may wirelessly transmit power to or receive power from an external device, using at least one antenna, and may support power transmission and/or reception of a magnetic induction scheme or power transmission and/or reception of a magnetic resonance scheme.

The communication module 1820 may support communication of various forms using at least one antenna, may support short-range communication, magnetic signal transmission and/or reception, and may support cellular communication. The at least one antenna may be at least one coil-shaped metal pattern 970 of FIG. 9.

The sensor module 1830 may detect various state information of the electronic device 1800. In some embodiments, the sensor module 1830 may detect various state information of an external electronic device, such as 1700 of FIG. 17.

The display 1840 may be designed to provide various screen interfaces required for management of the electronic device 1800, and may include a touch screen overlapping both a display panel and a touch panel.

The memory 1850 may store data, an application program or algorithm, corresponding to various operating systems and user functions that are required for management of the electronic device 1800, and may store instructions for various operations.

The processor 1860 may selectively activate at least a part of the wireless power transmission and/or reception module 1810 based on at least a part of at least one input, and may selectively activate at least a part of the communication module 1820 based on the at least part of the at least one input, such as a signal that is sensed through the sensor module 1830, that is inputted through any input device of the electronic device 1800, or that is wirelessly or wiredly received from an external electronic device.

When it is sensed that the external electronic device 1700 approaches from the sensor module 1830 or information regarding this approach is received from an external electronic device, the processor 1860 may enter a light receiving mode, and transmit a request for the light receiving mode to the external electronic device through the communication module 1820. In the light receiving mode, the processor 1860 may output an optical signal through a set position of a screen of the display 1840. Referring back to FIG. 9, the set position of the screen may be a position that is vertically aligned to at least one coil-shaped metal pattern 970 of the wireless power transmission and/or reception module 1810.

When receiving a response to the optical signal from the external electronic device through the communication module 1820, the processor 1860 may release the light receiving mode, transmit a request for a wireless power reception mode to the external electronic device, and enter a wireless power transmission mode, in which the processor 1860 may wirelessly transmit power through the wireless power transmission and/or reception module 1810.

The processor 1860 may receive a request for a wireless power transmission mode of a magnetic resonance scheme from an external electronic device through the communication module 1820, or enter the wireless power transmission mode of the magnetic resonance scheme, in which the processor 1860 may wirelessly transmit power in the magnetic resonance scheme through the wireless power transmission and/or reception module 1810.

In the wireless power transmission mode, the processor 1860 may acquire information about a charging state of an external electronic device, or a battery level of the electronic device 1800through the communication module 1820, and display this through the display 1840. For example, the information about the charging state of the external electronic device may include a charging time, a battery level, and the like. According to embodiments, in the wireless power transmission mode, the processor 1860 may determine whether to maintain the wireless power transmission mode or whether to release the wireless power transmission mode based on the charging state of the external electronic device, the battery level of the electronic device 1800, and the like. If the release of the wireless power transmission mode is determined, the processor 1860 may release the wireless power transmission mode, and transmit a request for wireless power reception mode release to the external electronic device.

The electronic device 1700 or 1800 may further include various modules in accordance with its provision form. With the convergence trend of digital devices, the electronic device 1700 or 1800 has a vast array of functions that may not all be described herein, but elements of levels similar to those described above may be further included in the above device. The electronic device 1700 or 1800 may also exclude specific elements from the above elements or replace the same with other elements in accordance with its provision form, which is easily understood by a person having ordinary skill in the art to which the present disclosure pertains.

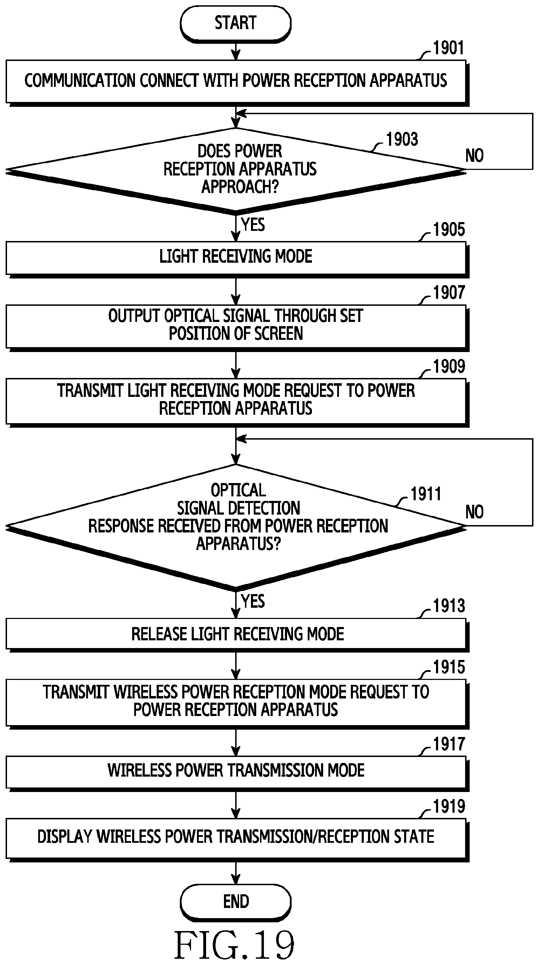

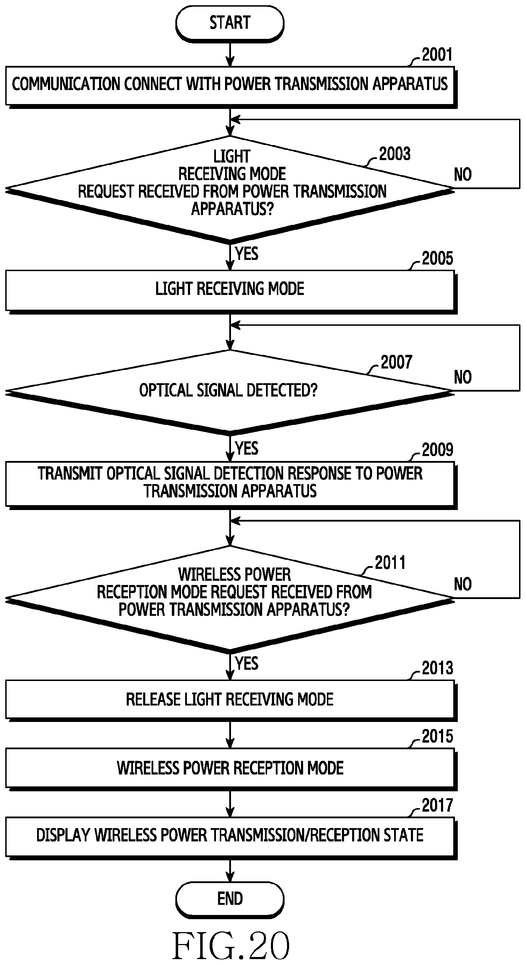

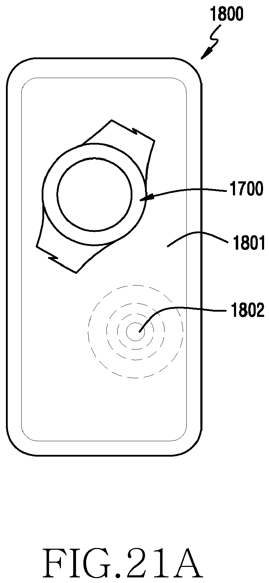

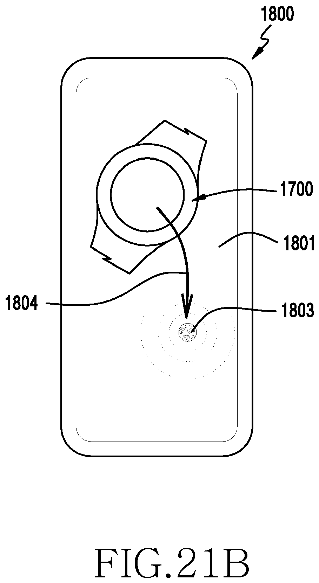

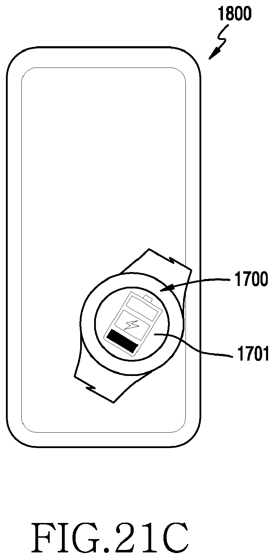

FIG. 19 illustrates a method of a power transmission apparatus according to an embodiment of the present disclosure. FIG. 20 illustrates a method of a power reception apparatus according to an embodiment of the present disclosure. FIGS. 21A, 21B and 21C illustrate the operation flow of the power transmission apparatus according to an embodiment of the present disclosure.

Referring to FIG. 19, in step 1901, the processor 1860 of the power transmission apparatus 1800 may be communication connected with a power reception apparatus 1700 through at least one wireless communication, such as short-range Bluetooth low energy (BLE).

In step 1903, the processor 1860 may determine whether the power reception apparatus 1700 approaches the power transmission apparatus 1800. Referring to FIG. 9, the power transmission apparatus 1800 may be similar to the apparatus 900 of FIG. 9, and thus may include a Hall sensor that is disposed between the display 920 and the second surface 9002. Referring to FIG. 21A when the power reception apparatus 1700 is applied to a screen 1801 of the power transmission apparatus 1800, or is located near the screen 1801, a Hall sensor 1802 installed within the power transmission apparatus 1800 may sense at least one magnetic material included in the power reception apparatus 1700. For example, the magnetic material may be included in a component such as a motor, or may be independently provided. The power transmission apparatus 1800 may estimate or determine a distance between the power reception apparatus 1700 and the Hall sensor 1802 based on a sensor value sensed from the Hall sensor 1802. When the sensor value sensed from the Hall sensor 1802 is greater than or equal to a threshold value, the power transmission apparatus 1800 may determine that the power reception apparatus 1700 approaches the power transmission apparatus 1800.

If it is sensed that the power reception apparatus 1700 approaches the power transmission apparatus 1800, the processor 1860 may perform step 1905, in which the processor 1860 may enter a light receiving mode. If it is not sensed that the power reception apparatus 1700 approaches the power transmission apparatus 1800, step 1903 is repeated.

In step 1907, the processor 1860 may output an optical signal through a set position 1803 of the screen, and may output light of a set wavelength or light emitting pattern.

In step 1909, the processor 1860 may transmit a light receiving mode request to the power reception apparatus 1700.

If an optical signal detection response is received from the power reception apparatus 1700, the processor 1860 may sense this in step 1911, and perform step 1913, described below. If an optical signal detection response is not received from the power reception apparatus 1700, step 1911 is repeated.

The power reception apparatus 1700 may receive the light receiving mode request from the power transmission apparatus 1800, and enter the light receiving mode to activate at least one light detector, such as a photo diode. Referring to FIG. 21B, if the power reception apparatus 1700 is moved to the position 1803 where an optical signal of the screen 1801 of the power transmission apparatus 1800 is outputted, the light detector of the power reception apparatus 1700 may detect an optical signal of a corresponding wavelength band. The position 1803 where the optical signal is outputted among the screen 1801 may be where an antenna 1710 of the power reception apparatus 1700 is aligned to an antenna of the power transmission apparatus 1800 for the sake of magnetic induction. Outputting of the optical signal in the set position 1803 of the screen 1801 may be for inducing a user to move the power reception apparatus 1700 to a suitable position for the sake of wireless power reception of a magnetic induction scheme.

In step 1913, the processor 1860 may release the light receiving mode and may stop the outputting of the optical signal in the set position 1803.

In step 1915, the processor 1860 may transmit a wireless power reception mode request to the power reception apparatus 1700, which may receive the wireless power reception mode request.

In step 1917, the processor 1860 may enter a wireless power transmission mode, in which the processor 1860 may form an electromagnetic field about wireless power through the power transmission and/or reception module 1810.

In step 1919, the processor 1860 may acquire and display a wireless power transmission and/or reception state. The power transmission apparatus 1800 may acquire, from the power reception apparatus 1700, information on a wireless power transmission time or a battery level, and may provide information on a battery charging state or a battery charging time to the power transmission apparatus 1800.

According to embodiments, steps 1903 to 1917 may be periodically performed. For example, the processor 1860 may periodically determine whether the power reception apparatus 1700 approaches the power transmission apparatus 1800, and whether the power reception apparatus 1700 transmits an optical signal detection response in a light receiving mode and, in accordance with the determination result, may control the activation of a wireless power transmission mode of the power transmission apparatus 1800 and a wireless power reception mode of the power reception apparatus 1700.

Referring to FIG. 20, in step 2001, the control circuit 1740 of the power reception apparatus 1700 may be communication connected with the power transmission apparatus 1800, such as by short-range communication.

In step 2003, if a light receiving mode request is received from the power transmission apparatus 1800, the control circuit 1740 of the power reception apparatus 1700 may sense the request.

In step 2005, the control circuit 1740 of the power reception apparatus 1700 may enter a light receiving mode, in which the control circuit 1740 of the power reception apparatus 1700 may activate at least one light detector of the sensor circuit 1730. The at least one light detector may be a light detector for medical recognition of various forms. For example, referring to FIG. 4B, in the light receiving mode, the power reception apparatus, such as the electronic device 400, may activate the light receiving unit 495 of the at least one sensor 493. If in step 2003 a light receiving mode request is not received from the power transmission apparatus 1800, step 2003 is repeated.

In step 2007, if an optical signal generated from the power transmission apparatus 1800 is detected by the at least one light detector, the control circuit 1740 of the power reception apparatus 1700 may sense this signal. Referring to FIG. 21B, the position 1803 where the optical signal is outputted among the screen 1801 of the power transmission apparatus 1800 may be a position where an antenna 1710 of the power reception apparatus 1700 is aligned to an antenna of the power transmission apparatus 1800 for the sake of magnetic induction.

In step 2009, the control circuit 1740 of the power reception apparatus 1700 may transmit an optical signal detection response to the power transmission apparatus 1800, by notifying that the power reception apparatus 1700 is located in a position where the power reception apparatus 1700 is able to receive wireless power by magnetic induction from the power transmission apparatus 1800. If an optical signal generated from the power transmission apparatus 1800 is not detected by the at least one light detector, step 2007 is repeated.

In step 2011, if a wireless power reception mode request is received from the power transmission apparatus 1800, the control circuit 1740 of the power reception apparatus 1700 may sense this request.

In step 2013, the control circuit 1740 of the power reception apparatus 1700 may release the light receiving mode, by which at least one light detector may be deactivated.

In step 2015, the control circuit 1740 of the power reception apparatus 1700 may enter a wireless power reception mode in response to the wireless power reception mode request, in which mode the control circuit 1740 of the power reception apparatus 1700 may activate at least a part of the power transmission and/reception circuit 1721, to wirelessly receive power from the power transmission apparatus 1800.

In step 2017, the control circuit 1740 of the power reception apparatus 1700 may acquire a wireless power transmission and/or reception state, such as a charging state or battery level, and display this state on a screen, such as by displaying a battery level resulting from wireless power reception through a screen 1701.

The power reception apparatus 1700 may be positioned such that the screen 1701 faces a screen 1801 of the power transmission apparatus 1800, and the screen 1701 of the power reception apparatus 1700 may not be exposed. The power reception apparatus 1700 may acquire posture information on FIG. 8A, FIG. 8B or FIG. 13 using at least one of an acceleration sensor, a gyro sensor, or a gravity sensor, for example, and transmit this to the power transmission apparatus 1800. If the posture information of the power reception apparatus 1700 corresponds to FIG. 8A, the power reception apparatus 1700 may control to display a wireless power transmission and/or reception state under the control of the power transmission apparatus 1800 or for display on the screen 1701.

If the posture information of the power reception apparatus 1700 corresponds to FIG. 8A, the power transmission apparatus 1800 may display a wireless power transmission and/or reception state through one portion of the screen 1801, or deactivate the screen 1801. If the posture information of the power reception apparatus 1700 corresponds to FIG. 8B, the power transmission apparatus 1800 may be designed to display a wireless power transmission and/or reception state through its own screen 1801, and the power reception apparatus 1700 may deactivate the screen 1701 under the control of the power transmission apparatus 1800 or for itself. If the posture information of the power reception apparatus 1700 corresponds to FIG. 8C, the power reception apparatus 1700 may display a wireless power transmission and/or reception state through at least one of the screen 1801 of the power transmission apparatus 1800 and the screen 1701 of the power reception apparatus 1700.

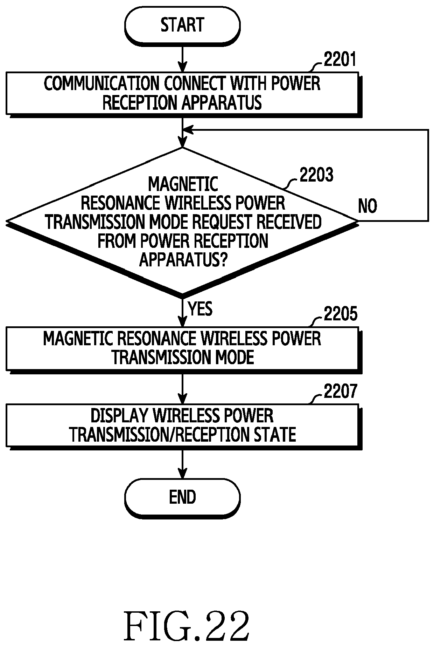

FIG. 22 illustrates a method of a power transmission apparatus according to an embodiment of the present disclosure.

Referring to FIG. 22, in step 2201, the processor 1860 may be communication connected with a power reception apparatus 1700.

In step 2203, if a request for a magnetic resonance wireless power transmission mode is received from the power reception apparatus 1700, the processor 1860 may sense this request. For example, when a magnetic resonance wireless power reception mode is selected through an input device installed in the power reception apparatus 1700, the power reception apparatus 1700 may enter the magnetic resonance wireless power reception mode, and transmit the magnetic resonance wireless power transmission mode request to the power transmission apparatus 1800. If a request for a magnetic resonance wireless power transmission mode is not received from the power reception apparatus 1700, step 2203 is repeated.

In step 2205, the processor 1860 may enter the magnetic resonance wireless power transmission mode, in which the processor 1860 may selectively activate at least a part of the power transmission and/or reception module 1810, to wirelessly transmit power in a magnetic resonance scheme.

In step 2207, the processor 1860 of the power transmission apparatus 1800 may acquire a wireless power transmission and/or reception state, such as a charging state or a battery level, and display this information on a screen.

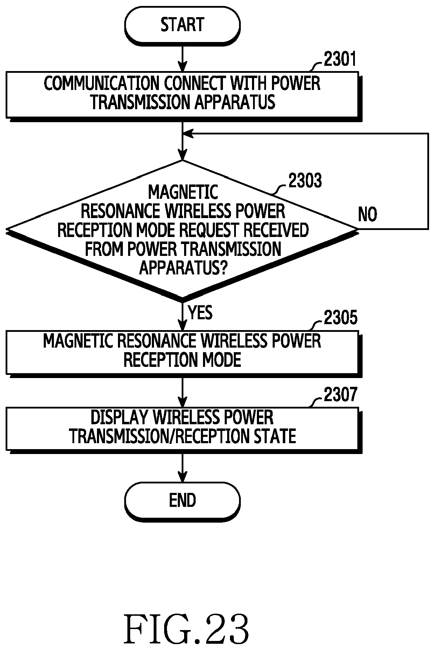

FIG. 23 illustrates a method of a power reception apparatus according to an embodiment of the present disclosure.

Referring to FIG. 23, in step 2301, the control circuit 1740 of the power reception apparatus 1700 may be communication connected with the power transmission apparatus 1800.

If a request for a magnetic resonance wireless power reception mode is received from the power transmission apparatus 1800, the control circuit 1740 may sense this in step 2303. For example, when a magnetic resonance wireless power transmission mode is selected through an input device installed in the power transmission apparatus 1800, the power transmission apparatus 1800 may enter the magnetic resonance wireless power transmission mode, and transmit a magnetic resonance wireless power reception mode request to the power reception apparatus 1700. If a request for a magnetic resonance wireless power reception mode is not received from the power transmission apparatus 1800, step 2303 is repeated.

In step 2305, the control circuit 1740 may enter the magnetic resonance wireless power reception mode, in which the control circuit 1740 may selectively activate at least a part of the power transmission and/reception circuit 1721, to wirelessly receive power in a magnetic resonance scheme

In step 2307, the control circuit 1740 of the power reception apparatus 1700 may acquire a wireless power transmission and/or reception state, and display this information on a screen.

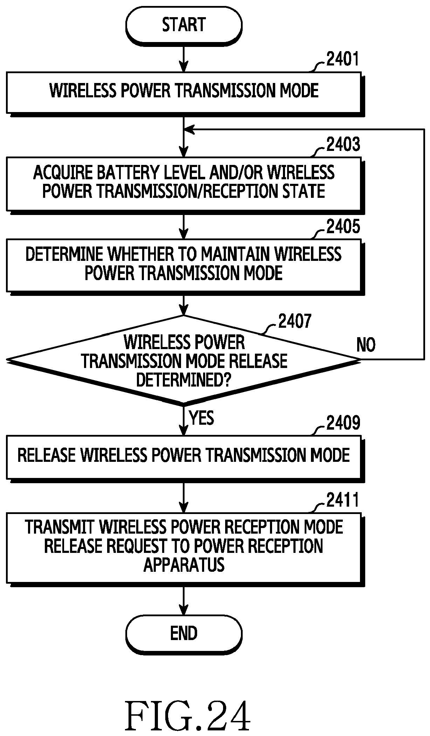

FIG. 24 illustrates a method of a power transmission apparatus according to an embodiment of the present disclosure.

Referring to FIG. 24, in step 2401, the processor 1860 of the power transmission apparatus 1800 may enter a wireless power transmission mode.

In step 2403, the processor 1860 may acquire a battery level and/or a wireless power transmission and/or reception state. The power transmission apparatus 1800 may acquire information on the wireless power transmission and/or reception state from the power reception apparatus 1700.

In step 2405, the processor 1860 may determine whether to maintain the wireless power transmission mode based on the battery level and/or the wireless power transmission and/or reception state. For example, when the battery level is equal to or is less than a set reference, the processor 1860 may determine to release the wireless power transmission mode, and alternatively, may determine to release the wireless power transmission mode when a wireless power transmission time exceeds the reference time.

The power transmission apparatus 1800 may be designed to maintain the wireless power transmission mode when the power transmission apparatus 1800 is wiredly or wirelessly receiving power from another external electronic device.

The reference on wireless power transmission mode maintenance or release may be designed by user environment setting.

If the release of the wireless power transmission mode is determined in step 2407, the processor 1860 may release the wireless power transmission mode in step 2409. If the maintenance of the wireless power transmission mode is determined in step 2407, the processor 1860 may repeat step 2403.

When releasing the wireless power transmission mode, in step 2411, the processor 1860 may transmit a request for wireless power reception mode release to the power reception apparatus 1700, which may receive the request for wireless power reception mode release, and release the wireless power reception mode.

A method for operating in an electronic device may include receiving a request for a light receiving mode from an external electronic device, entering the light receiving mode and, when a specific optical signal generated from the external electronic device is detected, transmitting a signal on this to the external electronic device, and when a request for a wireless power reception mode according to the signal is received from the external electronic device, releasing the light receiving mode, and entering the wireless power reception mode to receive wireless power from the external electronic device.

The method of the electronic device may further include displaying a wireless power reception state from the external electronic device through a display of the electronic device.

A specific optical signal generated from the external electronic device may be detected using a light receiving unit of a heart rate sensor.

An electronic device may secure a charging efficiency while performing wireless charging, even if the electronic device is not mounted in a defined direction on a wireless charging device.

An electronic device, such as a watch, may perform wireless charging using another electronic device, such as a smartphone, in place of a dedicated wireless charging device.

The aforementioned embodiments of the present disclosure may be composed as a program that is executable in a computer, and may be implemented in a generic digital computer that operates the program using a computer-readable recording medium. A structure of data used in the aforementioned embodiments of the present disclosure may be recorded in the computer-readable recording medium through various means. The computer-readable recording medium includes a storage medium such as a magnetic storage medium (for example, a floppy disc, a hard disc, etc.) and an optical reading medium (for example, a compact disc-ROM (CD-ROM), a digital versatile disc (DVD), etc.).

A person having ordinary skill in the art to which the present disclosure pertains would be able to understand that the present disclosure may be implemented in a modified form within a scope not departing from the intrinsic characteristic of the present disclosure. Therefore, the disclosed embodiments must be taken into consideration in a descriptive aspect, not in a restrictive aspect. The scope of the present disclosure is presented in the appended claims, not in the aforementioned description, and all differences within a scope equivalent thereto will have to be construed as being included in the present disclosure.

While the present disclosure has been shown and described with reference t o embodiments thereof, it will be apparent to those of ordinary skill in the art that various changes in form and detail may be made thereto without departing from the spirit and scope of the present disclosure as defined by the appended claims.

## Claims

1. An electronic device comprising:
a housing including a first surface facing in a first direction, and a second surface facing in a second direction that is opposite to the first direction;
a display disposed between the first surface and the second surface, and exposed through the first surface; and
a conductive line extending from a first end part to a second end part and including a plurality of turns that surround a space between the first surface and the second surface, and generating a magnetic field in the first direction or the second direction, or generating the magnetic field in a direction perpendicular to the first direction or the second direction.

2. The electronic device of claim 1, wherein the conductive line comprises a first conductive line surrounding the space, and wound in a coil form centering on an axis of the first direction, and generating the magnetic field in the first direction or second direction.

3. The electronic device of claim 1, wherein the conductive line comprises a second conductive line disposed in at least a part of a portion surrounding the space, and wound in a coil form centering on an axis of the direction perpendicular to the first direction, and generating a magnetic field in the direction perpendicular to the first direction.

4. The electronic device of claim 3, further comprising:
a bezel surrounding the space; and
a pair of extension parts combined to opposing sides of the bezel, and used for wearing on the wrist,
wherein the second conductive line is disposed in a direction perpendicular to a direction between the pair of extension parts.

5. The electronic device of claim 4, wherein at least one portion of the bezel overlapping with the second conductive line includes non-conductive materials.

6. The electronic device of claim 4, further comprising a first flexible film in which the first conductive line is disposed and a second flexible film is which the second conductive line, the first flexible and the second flexible separable from each other.

7. The electronic device of claim 1, further comprising:
at least one conductive plate surrounded by the plurality of turns of the conductive line, and disposed substantially in parallel with the first surface or second surface.

8. The electronic device of claim 7,
wherein the plurality of turns of the conductive line are disposed in a circular ring form along the space between the first surface and second surface, and
wherein the at least one conductive plate is a circular plate and is disposed inside the circular ring form.

9. The electronic device of claim 1, further comprising a flexible film in which the conductive line is disposed.

10. The electronic device of claim 9,
wherein the flexible film includes a first connector and a second connector which are electrically connected to the plurality of conductive lines and are disposed at opposite ends of the flexible film, respectively, and
wherein, by connecting the first connector and the second connector, the flexible film is disposed in the electronic device with a ring form surrounding the space between the first surface and the second surface, and the one conductive line is formed.

11. The electronic device of claim 10, wherein the flexible film comprises:
a multi-layer on which the majority of conductive lines are disposed; and
at least one via formed in the multi-layer,
wherein the at least one conductive line is formed by the electrical connection between the first connector and second connector and the at least one via.

12. The electronic device of claim 1, further comprising a circuit electrically connected to the first end part and second end part of the conductive line, and wirelessly receiving or transmitting power through the conductive line.

13. The electronic device of claim 12, wherein the circuit comprises at least one circuit among a wireless power transmission and/or reception circuit of a magnetic induction scheme and a wireless power transmission and/or reception circuit of a magnetic resonance scheme.

14. The electronic device of claim 1, further comprising:
at least one conductive plate surrounded by the conductive line, and disposed substantially in parallel with the first surface or second surface.

15. A method for operating an electronic device, the method comprising:
receiving a request for a light receiving mode from an external electronic device;
entering the light receiving mode;
when an optical signal generated from the external electronic device is detected, transmitting a response signal to the detected optical signal to the external electronic device;
releasing the light receiving mode when a request for a wireless power reception mode according to the response signal is received from the external electronic device; and
entering the wireless power reception mode and receiving wireless power from the external electronic device.
